# EUROPÄISCHE PATENTSCHRIFT

(11) **EP 4 062 503 B1**
(45) Veröffentlichungstag und Bekanntmachung des Hinweises auf die Patenterteilung: **30.04.2025**
(21) Anmeldenummer: 20803804.2
(22) Anmeldetag: 06.11.2020
(51) Int. Cl.: H02B 1/28, H05K 5/00

(54) **EXPLOSIONSGESCHÜTZTES GEHÄUSE**
EXPLOSION-PROOF HOUSING
BOÎTIER ANTIDÉFLAGRANT

(30) Priorität: 19.11.2019 DE 102019131195
(43) Veröffentlichungstag der Anmeldung: 28.09.2022
(73) Patentinhaber: R. STAHL Schaltgeräte GmbH, 74638 Waldenburg (DE)
(72) Erfinder: LIMBACHER, Bernd, 74523 Schwäbisch Hall (DE); KONDRUS, Elena, 74653 Künzelsau (DE); SEMRAU, Holger, 74589 Satteldorf (DE)
(74) Vertreter: Rüger Abel Patentanwälte PartGmbB
(86) Internationale Anmeldenummer: PCT/EP2020/081342
(87) Internationale Veröffentlichungsnummer: WO 2021/099147

(56) Entgegenhaltungen:
- DE-A1- 102007 003 009
- DE-A1- 19 959 384
- FR-A- 1 174 709
- US-A1- 2015 076 156

## Beschreibung

Die Erfindung betrifft ein explosionsgeschütztes Gehäuse, bevorzugt der Schutzart "druckfeste Kapselung".

Aus dem Stand der Technik sind Gehäuse bekannt, die nach der Explosionsschutzart "druckfeste Kapselung" ausgebildet sind. Diese erlaubt die Ansammlung eines explosionsfähigen Gasgemischs innerhalb des Gehäuses und eine Explosion desselben durch Zündfunken, gebildet durch ein elektrisches Betriebsgerät in dem Gehäuse. Entsprechend der Schutzart ist es auch zulässig, dass Gas oder Partikel bei der Explosion durch Spalte aus dem Inneren des Gehäuses nach außen dringen können, wo sich möglicherweise explosionsfähige Atmosphäre befindet. Allerdings muss entsprechend der Explosionsschutzart ausgeschlossen werden, dass das Gas derart heiß ist bzw. die Partikel derart heiß sind oder glühen, dass die explosionsfähige Atmosphäre außerhalb des Gehäuses entzündet werden kann.

DE 10 2010 016 782 A1 beschreibt eine Druckentlastungsvorrichtung für druckfest gekapselte Gehäuse. Dies ist dazu eingerichtet, in einem Gehäuseteil angeordnet zu werden und auch bei Ablauf einer explosionsartigen Reaktion in dem Innenraum die Größe der entstehenden Druckspitzen zu vermindern, indem entstehende Gase schnell und leicht durch die Druckentlastungsvorrichtung aus dem Gehäuse ausströmen können.

Aus der DE 34 36 300 C2 ist ein Gerätegehäuse mit einer explosionssicheren Kammer bekannt. Das Gehäuse weist als ein erstes Gehäuseteil einen Mantel und als ein zweites Gehäuseteil einen Deckel auf. Mantel und Deckel weisen korrespondierende Flansche auf, um eine Flanschverbindung zwischen dem Mantel und dem Deckel herzustellen. Spalte, durch welche Gas oder Partikel von dem Inneren des Gehäuses bei einer Explosion nach außen dringen können, zwischen den Flanschen, werden zugelassen. Diese sind jedoch so bemessen, dass ein innerhalb des Hohlraums des Gehäuses entzündetes Gas genügend abkühlt, bevor es das Gehäuse durch Spalte zwischen den Flanschen verlässt. Zwischen den Flanschen kann eine Dichtung angeordnet sein, um ein Eindringen von Feuchtigkeit in das Gehäuse zu verhindern.

Um die Spaltmaße für einen zünddurchschlagsicheren Spalt sicher einzuhalten, sind in im Stand der Technik bekannten Gehäusen gegenüberliegende Flanschflächen mit relativ engen Fertigungstoleranzen gefertigt. Zum Schließen des Gehäuses werden die Flansche unter Bildung eines zünddurchschlagsicheren Spalts aneinander angeordnet und der zünddurchschlagsichere Spalt zwischen den Flanschen wird gesichert, indem die Flansche gegeneinander gedrückt werden.

Aus der DE 26 17 965 B2 ist ein als druckfest bezeichnetes Gehäuse bekannt, welches ein Gehäuseunterteil und ein Gehäuseoberteil aufweist. Die beiden Teile bilden einen Zwischenraum, welcher als Spaltraum bezeichnet wird. Zwischen dem Gehäuseoberteil und dem Gehäuseunterteil ist an dem Spaltraum eine Dichtung angeordnet. Diese dient, zusammen mit Federelementen, dem Zusammenhalten des Gehäuseunterteils mit dem Gehäuseoberteil. Die Federelemente sind in dem Zwischenraum angeordnet. Der Zwischenraum ist mit Gießharz ausgegossen. Es ist angegeben, dass durch das Ausgießen des Spaltes mit Gießharz ein druckfestes Gehäuse erhalten werde, welches ohne Spalt ausgebildet sei.

DE 10 2007 003 009 A1 beschreibt ein Verfahren zur Herstellung von fluiddichten Gehäusen sowie ein fluiddichtes Gehäuse. Das Gehäuse weist ein Basisteil und eine plattenartige Abdeckung sowie eine zwischen einander zugewandten Flügelflächen von Basisteil und Abdeckung angeordnete Dichtung zur fluiddichten Abdichtung des Gehäuseinnenraums auf. Basisteil und Abdeckung werden aneinander vorgespannt befestigt, so dass die elastische Dichtung verformt ist. Damit wird ausgeschlossen, dass Gas aus der Umgebung des Gehäuses zu einer Zündquelle, welche sich innerhalb des fluiddichten Gehäuses befindet, gelangt.

Aus der DE 10 2013 111 374 A1 ist eine explosionsgeschützte Anordnung für elektrische und/oder elektronische Bauelemente bekannt. Die Anordnung weist einen Träger und einen Abdeckkörper auf. Der Abdeckkörper definiert wenigstens eine Aufnahmekammer für die Bauelemente. Zwischen dem Abdeckkörper und dem Träger ist ein elastisches Kopplungselement angeordnet, welches die Öffnung in dem Abdeckkörper vollständig umschließt. Wenn der Abdeckkörper und der Träger mittels einer kraftschlüssigen und/oder formschlüssigen Verbindung verbunden sind, wird dabei das Kopplungselement zwischen dem Abdeckkörper und dem Träger elastisch verformt. Mit der explosionsgeschützten Anordnung sollen die Anforderungen erreicht werden können, die diese für eine Vergusskapselung (Ex-m) oder eine druckfeste Kapselung (Exd) definiert sind. Bei der Vergusskapselung (Ex-m) wird eine explosionsfähige Atmosphäre aus dem Innenraum eines Gehäuses ausgeschlossen.

DE 1 801 062 A offenbart ein druckfestes Gehäuse aus durch Schweißen verbundenen Stahlblechteilen. Das Gehäuse weist einen Ring auf, welcher in eine Öffnung in einer Wand des Gehäuses mit einer Schweißverbindung eingesetzt ist. Der Ring weist eine konische Passfläche als Sitz für einen Deckel auf. Der Deckel kann an dem Gehäuse durch eine bajonettartige Verriegelung gehalten sein. Eine Passung zwischen dem Ring und dem Deckel macht das Einhalten enger Toleranzen erforderlich, was die Kosten für die Herstellung erhöht.

GB 778 040 offenbart ein Gehäuse mit einem Teil, welches einen Innenraum des Gehäuses festlegt und eine Öffnung aufweist, welche bei geöffnetem Gehäuse einen Zugriff in den Innenraum erlaubt, und mit einem zweiten Teil zum Schließen der Öffnung. Zwischen dem ersten Teil und dem zweiten Teil ist ein elastisch verformtes, offenporiges Element angeordnet, welches den Zwischenraum zwischen dem ersten Teil und dem zweiten Teil zünddurchschlagsicher schließt. Wenn das Gehäuse ohne Austauschen des Elements wiederverschließbar ist, muss darauf geachtet werden, dass das Element im geöffneten Zustand nicht beschädigt wird.

Aus der FR 1 174 709 ist ein mit einem Flansch versehenes Gehäuse bekannt, das durch einen auf dem Flansch aufliegenden Deckel geschlossen ist. Der Flansch und der Deckel werden durch eine genutete Leiste übergriffen, wobei die Leiste mit einer schräg stehenden Innenfläche und der Deckel mit einer Keilfläche klemmend zusammenwirken. Damit wird der Rand des Deckels gegen den Flansch flächig gespannt.

Eine ähnliche Konstruktion offenbart die US 2015/0076156 A1, bei der allerdings die Keilfläche an der Flanschunterseite angebracht ist.

Die DE 199 59 384 A1 offenbart andere Beispiele von druckfeste Montage von explosionsgeschützten Gehäuseteilen mittels äußerer Klemmteile.

Es kann als eine Aufgabe angesehen werden, ein verbessertes Konzept für ein explosionsgeschütztes Gehäuse anzugeben. Diese Aufgabe wird mit einem explosionsgeschützten Gehäuse nach Anspruch 1, einem Verfahren nach Anspruch 14 sowie einem Verfahren nach Anspruch 15 gelöst:
Das explosionsgeschützte Gehäuse bildet einen Innenraum zur Aufnahme von Komponenten, welche Zündquellen bilden können. Das Gehäuse weist ein erstes Gehäuseteil mit einem ersten Abschnitt, welcher eine erste Fläche aufweist, und ein zweites Gehäuseteil mit einem zweiten Abschnitt auf, welcher eine zweite Fläche aufweist. Der erste Abschnitt und/oder der zweite Abschnitt ist ein Wandabschnitt. Die Wand, deren Abschnitt der erste Abschnitt oder der zweite Abschnitt ist, kann eine Seitenwand, ein Boden oder Rücken oder ein Deckel oder ein sonstiger Verschluss (beispielsweise ein Frontverschluss oder ein Rückseitenverschluss) sein. Die erste Fläche und die zweite Fläche begrenzen einen Zwischenbereich, welche eine Trennstelle des Gehäuses ist. Der erste Abschnitt und der zweite Abschnitt sind unter elastischer Verformung des Wandabschnitts unmittelbar (direkt) und/oder mittelbar über wenigstens eine Zwischenlage gegeneinander mittels einer Verspannvorrichtung gedrückt, so dass der Zwischenbereich geometrisch von der elastischen Verformung des Wandabschnitts zünddurchschlagsicher geschlossen ist. Erfindungsgemäß wird ein Verfahren zum Herstellen eines Gehäuses, beispielsweise eines hierin beschriebenen erfindungsgemäßen Gehäuses angegeben. Das Verfahren weist das Auswählen eines ersten Abschnitts und eines zweiten Abschnitts zum Begrenzen eines Zwischenbereichs des Gehäuses auf, wobei wenigstens einer der Abschnitte ein Wandabschnitt ist, derart, dass der erste Abschnitt und der zweite Abschnitt unter elastischer Verformung des Wandabschnitts gegeneinander drückbar sind, so dass der Zwischenbereich geometrisch von der elastischen Verformung des Wandabschnitts zünddurchschlagsicher geschlossen wird.

Ein weiteres erfindungsgemäßes Verfahren dient der Herstellung einer explosionsgeschützten Verbindung zwischen einem ersten Abschnitt eines ersten Gehäuseteils mit einer ersten Fläche und einem zweiten Abschnitt eines zweiten Gehäuseteils mit einer zweiten Fläche. Dieses Verfahren kann beispielsweise bei einem hierin beschriebene erfindungsgemäßen Gehäuse angewendet werden. Das Verfahren weist das Zusammensetzen des ersten Gehäuseteils und des zweiten Gehäuseteils auf, um das Gehäuse zu schließen, wobei die erste Fläche und die zweite Fläche einen Zwischenbereich begrenzen, welcher ein Spaltmaß außerhalb eines zünddurchschlagsicheren Bereichs aufweist. Die Abschnitte werden mit einer Kraft beaufschlagt, so dass der Zwischenbereich von der elastischen Verformung des Wandabschnitts zünddurchschlagsicher geometrisch geschlossen wird.

In Ausführungsformen kann der Zwischenbereich bis auf eine Weite Null geschlossen werden, also ein zünddurchschlagsicherer Nullspalt sein, oder in dem Zwischenbereich kann ein zünddurchschlagsicherer Spalt der Spaltweite Null ausgebildet sein.

Im Stand der Technik werden zur Herstellung einer zünddurchschlagsicheren Verbindung zwischen zwei Elementen eines Gehäuses, zwischen denen ein zünddurchschlagsicherer Spalt ausgebildet ist, die Gehäuseteile so geformt, insbesondere nachbearbeitet, dass diese zur Ausbildung des zünddurchschlagsicheren Spalts zwischen den Gehäuseteilen zueinander passen. Erfindungsgemäß wird ein Spalt, welcher die maximale Länge und Weite für Zünddurchschlagsicherheit einhält, sicher erst beim Drücken des ersten und des zweiten Abschnitts gegeneinander unter elastischer Verformung des wenigstens einen Wandabschnitts gebildet. Ein Drücken des zweiten Gehäuseteils gegen das erste Gehäuseteil dient folglich nicht - wie beim Stand der Technik - dem Sichern eines schon bei Anlage zweier Flächen der Gehäuseteile entstehenden zünddurchschlagsicheren Spalts, sondern das Bilden der zünddurchschlagsicheren Spaltmaße wird erst von der Verformung des ersten Abschnitts und/oder des zweiten Abschnitts im Zuge der Verbindung des zweiten Gehäuseteils mit dem ersten Gehäuseteil sichergestellt.

Das Verformen des ersten Abschnitts und/oder des zweiten Abschnitts führt bevorzugt zu einer Verformung der Fläche des ersten Abschnitts und/oder der Fläche des zweiten Abschnitts und/oder einer Verminderung eines von den Flächen festgelegten Winkels, welche Flächen die Weite des Zwischenbereichs definieren und damit zu einer Abnahme der Weite des Zwischenbereichs, so dass der Zwischenbereich zünddurchschlagsicher geschlossen wird. Der erste Abschnitt und der zweite Abschnitt können einen Keilspalt bilden, wobei der Spalt die Keilform als Sollform auf Grund der Sollformen des ersten Abschnitts und des zweiten Abschnitts erhalten kann oder wobei der Spalt die Keilform auf Grund einer von den Sollformen abweichenden vorbestimmten Form des ersten Abschnitts und des zweiten Abschnitts aufweisen kann. Durch die elastische Verformung wird der Keilspalt weiter geschlossen, wobei der Keilspalt seine Keilform behalten oder verlieren kann.

Das erfindungsgemäße Konzept stellt geringere Anforderungen an Toleranzen der die Trennstelle begrenzenden Gehäuseteile. Das erfindungsgemäße Konzept macht auch Zwischenbereiche möglich, welche von einer Flachspaltform abweichen, z.B. gewölbte Spalte (z.B. im Querschnitt U-förmige Spalte) oder beispielsweise V- oder W-förmige Spalte.

Erfindungsgemäß kann das Verformen des ersten Gehäuseteils und/oder des zweiten Gehäuseteils gezielt dazu verwendet werden, grobe Toleranzen des ersten Gehäuseteils/zweiten Gehäuseteils oder eine gezielt abweichende Form durch das Verformen auszugleichen. Das Verformen wird als Mittel zum Herstellen der Zünddurchschlagsicherheit benutzt.

Das explosionsgeschützte Gehäuse kann beispielsweise nach der Schutzart "druckfeste Kapselung" gemäß der Norm (DIN EN 600-79/1) oder einer amerikanischen Norm (beispielsweise) ausgebildet sein.

Weitere vorteilhafte, optionale Merkmale und Ausführungsformen des erfindungsgemäßen Gehäuses und der erfindungsgemäßen Verfahren ergeben sich beispielsweise aus der folgenden Beschreibung:
In Ausführungsformen des Gehäuses ist der erste Abschnitt des ersten Gehäuseteils und/oder der zweite Abschnitt des zweiten Gehäuseteils ein Blechabschnitt. Wenn das erste Gehäuseteil und/oder das zweite Gehäuseteil ein Blechteil sind, lassen sich Gehäuse besonders geringen Gewichts herstellen. Das erste Gehäuseteil und/oder das zweite Gehäuseteil können tiefgezogene Blechteile sein. Die Blechdicke des ersten Abschnitts und/oder die Blechdicke des zweiten Abschnitts kann in Ausführungsformen beispielsweise 5 Millimeter oder weniger betragen, beispielsweise 3 Millimeter oder weniger. Je geringer die Blechdicke desto geringer ist auch die für die Verformung zum zünddurchschlagsicheren Schließen erforderliche Kraft.

In bevorzugten Ausführungsformen des explosionsgeschützten Gehäuses drücken der erste Abschnitt und der zweite Abschnitt gegeneinander unter elastischer Verformung sowohl des zweiten Abschnitts als auch des ersten Abschnitts, um den Zwischenbereich zwischen dem ersten Abschnitt und dem zweiten Abschnitt zünddurchschlagsicher zu schließen. In solchen Ausführungsformen trägt sowohl eine Verformung des zweiten Abschnitts als auch eine Verformung des ersten Abschnitts aufeinander zu maßgeblich dazu bei, den Zwischenbereich zünddurchschlagsicher zu schließen. Bevorzugt sind die elastische Verformbarkeit des ersten Abschnitts des ersten Gehäuseteils und die elastische Verformbarkeit des zweiten Abschnitts des zweiten Gehäuseteils so groß, dass der erste Abschnitt und der zweite Abschnitt beim Verformen zum zünddurchschlagsicheren Schließen des Zwischenbereichs Wegstrecken aufeinander zu zurücklegen, deren Längen sich um maximal einen Faktor 10 unterscheiden.

Das erste Gehäuseteil und das zweite Gehäuseteil können vorbestimmte Formen aufweisen, so dass diese auch bei direkter Anlage des zweiten Gehäuseteils an dem ersten Gehäuseteil, zumindest im nicht zünddurchschlagsicher gegeneinander drückenden Zustand, den Zwischenbereich, welcher dazu bestimmt ist, durch Verspannen zünddurchschlagsicher geschlossen zu werden, mit einer von Null verschiedenen Weite zu begrenzen.

Der erste Abschnitt und der zweite Abschnitt können voneinander abweichende vorbestimmte Formen aufweisen. Vorbestimmte Formen sind solche, welche Formen und/oder Abmessungen im vorbestimmten Toleranzfeld um die spezifizierte Form (Sollform) aufweisen.

Der erste Abschnitt und der zweite Abschnitt weisen zumindest ohne die elastische Verformung keine derart zueinander passende Form auf, dass eine Zünddurchschlagsichere Zwischenbereichsgeometrie bereits ohne Verformung vorhanden wäre, und sind insofern keine Passflächen. Zumindest ohne die elastische Verformung können der ersten Abschnitt und der zweite Abschnitt (deren Oberflächen) stark voneinander abweichende Sollformen oder vorbestimmte Formen aufweisen.

Der erste Abschnitt und der zweite Abschnitt können unterschiedliche Sollformen aufweisen, so dass bei Anlage des ersten Gehäuseteils an dem zweiten Gehäuseteil im unverspannten Zustand des ersten Abschnitts und des zweiten Abschnitts der erste Abschnitt und der zweite Abschnitt auf Grund der geometrischen Sollformen einen Winkel einschließen.

Die Weite des Zwischenbereichs kann beim Abstützen des ersten Gehäuseteils und des zweiten Gehäuseteils aneinander, zumindest im nicht zünddurchschlagsicher gegeneinander drückenden Zustand auf Grund der Sollform des ersten Abschnitts und des zweiten Abschnitts von einem Abstützbereich in Richtung zu der Umgebung des Gehäuses und/oder in Richtung zu dem Innenraum zunehmen.

Bevorzugt stützt sich der Abschnitt an dem Gegenabschnitt beim zünddurchschlagsicher Schließen des Zwischenbereichs durch elastisches Verformen direkt oder indirekt in einem festgelegten Abstützbereich ab, wobei der Abstützbereich einen inneren Rand und/oder einen äußeren Rand des Zwischenbereichs bildet und/oder wobei der Abstützbereich zwischen einem inneren Rand und einem äußeren Rand des Zwischenbereichs angeordnet ist.

Der erste Abschnitt und/oder der zweite Abschnitt können Biegefedern und/oder Arme eines einseitigen Hebels bilden, welche entfernt von dem Abstützbereich beim elastischen Verformen zum zünddurchschlagsicher Schließen relativ gesehen aufeinander zubewegt werden.

Beim Verformen kann ein Winkel, den die Abschnitte vor der Verformung auf Grund abweichender Sollformen und/oder abweichender vorbestimmter Formen einschließen, verringert werden (z.B. auf Null). Der erste Abschnitt und/oder der zweite Abschnitt werden aneinander erst durch das Verformen angepasst. Unter "Anpassen" wird ein Prozess hin zu einer komplementären Formen der Abschnitte verstanden, ohne notwendigerweise die komplementären Formen erreichen zu müssen. Für das zünddurchschlagsichere Verschließen ist es nicht unbedingt erforderlich, dass dieser Prozess zu einer komplementäre Form führt. Vielmehr kann die Zwischenbereichsgeometrie auch ohne Erreichen von komplementären Formen durch Verformung in den Bereich der Geometrie von zünddurchschlagsicheren Spalten fallen, wobei der Zwischenbereich nach Verformung frei oder gefüllt sein kann. Der erste Abschnitt und der zweite Abschnitt können durch das Verformen komplementäre Formen erhalten. In anderen Ausführungsformen wird ein Winkel zwischen den Oberflächen des ersten Abschnitts und des zweiten Abschnitts der vor dem Verformen bestand, auf Grund des Verformens zumindest verringert.

Der erste Abschnitt und/oder der zweite Abschnitt können eine langgestreckte Aufnahme, z.B. eine Sicke, bilden. Die Aufnahme kann im Querschnitt des ersten Abschnitts und/oder des zweiten Abschnitts beispielsweise U-förmig, V-förmig oder W-förmig sein. Der zweite Abschnitt und/oder der erste Abschnitt weist eine langgestreckte Vorwölbung auf, welche in der Aufnahme aufgenommen ist. In Ausführungsformen weisen die gegenüberliegende Flächen der Vorwölbung und der Aufnahme im nicht zünddurchschlagsicher gegeneinander gedrückten Zustand voneinander abweichende Formen auf, beispielsweise V-Formen mit unterschiedlichen Öffnungswinkeln oder U-Formen mit unterschiedlicher Krümmung. Bei der Verspannung des ersten Abschnitts und des zweiten Abschnitts zur Herstellung der Zünddurchschlagsicherheit können der erste Abschnitt und/oder der zweite Abschnitt und damit die Flächen in Ausführungsbeispielen derart verformt werden, dass sich die zuvor nicht komplementären Formen flächig aneinander schmiegen. Wenn der erste Abschnitt und/oder der zweite Abschnitt verformt sind, kann die Oberfläche des Blechelements die Oberfläche des weiteren Elements flächig berühren. Der zünddurchschlagsichere Zwischenbereich kann ein Spalt der Spaltweite 0 bilden. Der Zwischenbereich kann insbesondere ein Spalt der Spaltweite 0 sein.

Der Zwischenbereich kann im verspannten Zustand frei von einer Festkörperfüllung sein oder mit einem elastisch verformten Festkörper gefüllt sein. In Ausführungsformen kann zwischen dem ersten Abschnitt und dem zweiten Abschnitt wenigstens eine elastisch verformte Zwischenschicht angeordnet sein, mittels welcher der erste Abschnitt und der zweite Abschnitt gegeneinander gedrückt sind. Zwischen dem ersten Abschnitt und dem zweiten Abschnitt kann ein elastisch verformtes Zwischenelement angeordnet sein. Der erste Abschnitt und der zweite Abschnitt können vermittelt über das Zwischenelement gegeneinander gedrückt sein. Die Zwischenschicht und/oder das Zwischenelement können gesondert von dem ersten Abschnitt und/oder dem zweiten Abschnitt sein oder mit dem ersten Abschnitt oder dem zweiten Abschnitt stoffschlüssig verbunden sein, z.B. verklebt. Das Zwischenelement kann beispielsweise rahmenförmig sein, um eine Öffnung des Gehäuses zu umgeben. Das Zwischenelement kann aus Kunststoff sein.

Der Zwischenbereich kann mit einer Abmessungsrichtung (z.B. Längenrichtung, Breitenrichtung, Höhenrichtung), also einer Richtung, in welcher eine Abmessung des Gehäuses gemessen wird, einen von Null Grad verschiedenen Winkel einschließen. In bekannten Gehäusen mit zünddurchschlagsicherem Flachspalt ist der Flachspalt beispielsweise parallel zur Breitenrichtung des Gehäuses oder zur Längenrichtung des Gehäuse oder zur Höhenrichtung des Gehäuses ausgebildet. Wenn ein Zwischenbereich, insbesondere in spaltförmiger Zwischenbereich einen Winkel mit einer Abmessungsrichtung einschließt, kann das Gehäuse in dieser Richtung eine geringere Abmessung haben, als wenn der Zwischenbereich beispielsweise parallel zu der Abmessungsrichtung ausgerichtet ist. Dies macht das Herstellen von besonders kompakten Gehäusen oder Gehäusen mit optimiert großen Innenvolumen möglich.

In bevorzugten Ausführungsformen sind der Zwischenbereich und/oder die erste Fläche und die zweite Fläche, welche den Zwischenbereich begrenzen, schräg bezüglich einer Wand des Gehäuses orientiert. Der Zwischenbereich und/oder der erste Abschnitt und/oder der zweite Abschnitt können mit der Wand des Gehäuses einen von 90° abweichenden Winkel einschließen, der größer als 0° und kleiner als 180° ist. Der Zwischenbereich, der erste Abschnitt und/oder der zweite Abschnitt können insbesondere schräg von einer Wand des Gehäuses abstehen, und zwar nach außen oder nach innen.

Der erste Abschnitt und/oder der zweite Abschnitt kann beispielsweise ein von einer Wand des Gehäuses nach außen, d.h. in Richtung zu der Umgebung des Gehäuses, oder nach innen, d.h. in Richtung zu dem Innenraum des Gehäuses, auskragender Abschnitt sein.

In bevorzugten Ausführungsformen weist der erste Abschnitt und/oder der Gegenabschnitt eine Einrichtung zur Festlegung einer Biegezone auf. Die Biegezone kann beispielsweise durch Vorsehen eines Bereiches in dem Blechmaterial mit einer verglichen mit einem sonstigen Bereich des ersten Abschnitts verminderten Wandstärke festgelegt sein. Der Bereich kann linienförmig sein. Der Bereich kann insbesondere einer geraden Linie folgen. Die Einrichtung kann beispielsweise eine rinnenförmige Vertiefung in dem Abschnitt oder dem Gegenabschnitt sein. Die Biegezone kann einer geraden Linie folgen. Eine höhere Nachgiebigkeit in der Biegezone kann alternativ oder zusätzlich zu einer geringeren Wandstärke durch beispielsweise eine Gefügeveränderung in einem Bereich des Blechmaterials festgelegt sein. Insbesondere wenn eine Einrichtung zur Festlegung einer Biegezone in dem Abschnitt und/oder dem Gegenabschnitt vorhanden ist, können die Formveränderungen beim Verspannen besonders genau vorherbestimmt sein. Das Material, insbesondere Blechmaterial, des Abschnitts und/oder des Gegenabschnitts kann mit einer solchen Einrichtung gezielter einerseits stark genug ausgebildet sein, um einer Explosion standhalten zu können und andererseits biegsam genug, um den Kraftaufwand zum Verformen zur Ausbildung des zünddurchschlagsicheren Zwischenbereichs klein zu halten.

In bevorzugten Ausführungsformen ist das Gehäuse wiederverschließbar. Bevorzugt sind zum Wiederverschließen der erste Abschnitt und der zweite Abschnitt wiederholt unter elastischer Verformung des einen oder der mehreren Wandabschnitte gegen einander drückbar, um den Zwischenbereich zwischen dem ersten Abschnitt und dem zweiten Abschnitt erneut zünddurchschlagsicher zu schließen.

Besonders dünne Blechstärken werden möglich, wenn dem Gehäuse eine innere und/oder äußere Druckentlastungsvorrichtung zugeordnet ist. Die dem Gehäuse vorzugsweise zugeordnete Druckentlastungsvorrichtung ist vorzugsweise dazu eingerichtet und bestimmt, den maximalen Überdruck, welcher aufgrund einer Explosion im Inneren des Gehäuses entsteht, auf einen Maximalwert zu beschränken, welcher kleiner als der Maximalwert ist, welcher in demselben Gehäuse ohne die wenigstens eine Druckentlastungsvorrichtung auftreten würde.

Die wenigstens eine Vorrichtung zur Explosionsdruckreduzierung kann einen Druckentlastungskörper aufweisen, welcher in oder an eine Öffnung des Gehäuses zur Umgebung des Gehäuses angeordnet ist, um im Falle einer Explosion Gas aus dem Inneren des Gehäuses zur Entlastung zu entlassen (äußere Druckentlastungsvorrichtung). Ein solcher Druckentlastungskörper ist vorzugsweise entsprechend der Schutzart "druckfeste Kapselung" (z.B. Ex-d, EN 600 79-1) zünddurchschlagsicher ausgebildet.

Alternativ oder zusätzlich kann die wenigstens eine Vorrichtung zur Explosionsdruckreduzierung eine Einrichtung aufweisen, welche Gas nicht aus dem Gehäuse entweichen lassen kann, welche aber Wärme- und/oder Bewegungsenergie aus der Explosion aufnehmen kann, um den maximalen Überdruck aufgrund der Explosion zu beschränken (innere Druckentlastungsvorrichtung).

Die Druckentlastungsvorrichtung zur Reduzierung von Explosionsdruck weist vorzugsweise offenporiges Material auf. Offenporiges Material kann aufgrund seiner großen Oberfläche das Gas effektiv kühlen, um den maximalen Explosionsdruck zu reduzieren. Offenporiges Material kann beispielsweise Fasermaterial, beispielsweise Metallfasermaterial, sein, z.B. zu einem Gewebe, einem Gelege oder einem Filz verarbeitete Fasern sein, oder aus einer Schüttung aus rieselfähigem Material gebildet sein.

Die Druckentlastungsvorrichtung kann beispielsweise dazu eingerichtet und bestimmt sein, den Überdruck auf Grund einer Explosion auf einen Maximalwert von 1000 Millibar oder kleiner oder besonders bevorzugt einen Maximalwert von 500 Millibar oder kleiner zu beschränken. Die wenigstens eine Druckentlastungsvorrichtung zur Reduzierung von Explosionsdruck ist vorzugsweise dazu eingerichtet und bestimmt, einen Explosionsüberdruck (Überdruck über Atmosphärendruck) von einigen Bar, insbesondere größer oder gleich 10 Bar, der auftreten würde, wenn die wenigstens eine Vorrichtung in dem ansonsten unveränderten Gehäuse nicht vorgesehen wäre, auf einen Überdruck von beispielsweise kleiner oder gleich 1 Bar zu reduzieren.

In Ausführungsformen kann das Innenvolumen des Gehäuses 1 Liter oder mehr, 10 Liter oder mehr, 50 Liter oder mehr, 100 Liter oder mehr, 500 Liter oder mehr oder 1000 Liter oder mehr betragen.

Weitere optionale vorteilhafte Merkmale und Ausführungsformen ergeben sich aus den Unteransprüche, der nachfolgenden Beschreibung sowie den Figuren. Es zeigen beispielhaft:
Figur 1a - ein Beispiel eines erfindungsgemäßen Gehäuses in einer perspektivischen Darstellung,
Figur 1b - ein erste Gehäuseteil des Gehäuses gemäß Figur 1a in perspektivischer Darstellung,
Figur 1c - ein zweites Gehäuseteil des Gehäuses gemäß Figur 1a,
Figur 2 - eine Querschnittsansicht durch einen ersten Abschnitt und einen zweiten Abschnitt des Gehäuses gemäß Figur 1a (entlang eines Abschnitts der Schnittlinie S1),
Figur 3 - eine Querschnittsansicht durch einen ersten Abschnitt und einen zweiten Abschnitt des Gehäuses gemäß Figur 1a im verspannten Zustand,
Figur 4 - ein Ausschnitt (entlang der Schnittlinien S1 und S2, senkrecht zu dem zweiten Gehäuseteil) des Gehäuses gemäß Figur 1a in perspektivischer schematischer, nicht maßstabsgetreuer Darstellung,
Figur 5 - eine Querschnittsansicht durch einen ersten Abschnitt und einen zweiten Abschnitt des Gehäuses gemäß Figur 1a im nicht verspannten Zustand entlang eines Abschnitts der Schnittlinie S1,
Figur 6a - eine Schnittansicht einer Abwandlung des Gehäuses gemäß Figur 1a entlang eines Abschnitts der Schnittlinie S1 und S2,
Figur 6b - eine Querschnittsansicht durch den ersten Abschnitt und den zweiten Abschnitt der Gehäuseteile des Gehäuses gemäß Figur 6a entlang eines Abschnitts der Schnittlinie S1,
Figur 6c - schematisiert und ausschnittsweise die Querschnittdarstellung durch den ersten Abschnitt und den zweiten Abschnitt gemäß Figur 6b entlang eines Abschnitts der Schnittlinie S1,
Figur 7 - eine ausschnittsweise Querschnittdarstellung durch eine Abwandlung des Ausführungsbeispiels gemäß Figur 6a entlang eines Abschnitts der Schnittlinie S1,
Figur 8a, 8b - eine ausschnittsweise Querschnittdarstellung durch eine weitere Abwandlung des Ausführungsbeispiels gemäß Figur 6a im unverspannten (Figur 8a) und verspannten Zustand (Figur 8b) entlang eines Abschnitts der Schnittlinie S1,
Figur 9a - ein Ausschnitt des Gehäuses gemäß einer weiteren Ausführungsform in perspektivischer Darstellung entlang der Schnittlinien S1 und S2, schematisch, nicht maßstabsgetreu,
Figur 9b - eine ausschnittsweise Querschnittdarstellung gemäß Ausführungsbeispiels gemäß Figur 9b entlang der Schnittlinie S1,
Figur 9c - eine ausschnittsweise Querschnittdarstellung durch eine Abwandlung des Ausführungsbeispiels gemäß Figur 9a entlang der Schnittlinie S1,
Figur 10a - eine schematische Querschnittdarstellung durch ein erstes und ein zweites Gehäuseteil einer weiteren Ausführungsform des erfindungsgemäßen Gehäuses,
Figur 10b - eine schematische Querschnittdarstellung durch das Gehäuses mit verspannten ersten und zweiten Gehäuseteilen,
Figur 10c - eine Darstellung einer Abwandlung der Ausführungsform gemäß Figuren 10a und 10b,
Figur 11a, 11b - zwei beispielhafte Ansichten auf eine Fläche eines ersten Abschnitts des ersten Gehäuseteils des Gehäuses der Figur 10b,
Figuren 12a - eine Veranschaulichung eines Ausführungsbeispiels eines erfindungsgemäßen Verfahrens und
Figur 12b - eine Veranschaulichung eines Ausführungsbeispiels eines weiteren erfindungsgemäßen Verfahrens.

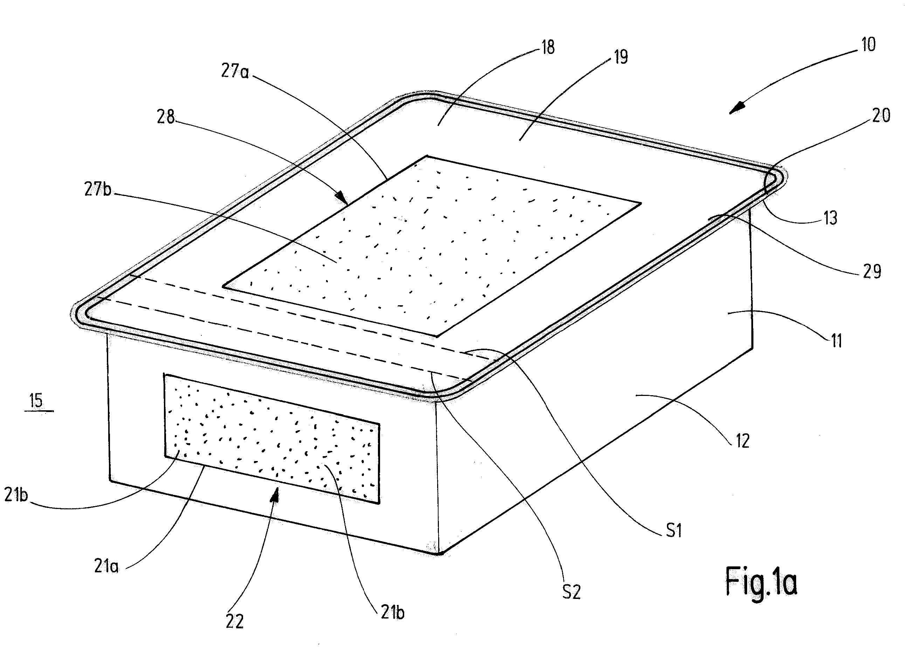

Die Figur 1a bis 1c zeigen ein Ausführungsbeispiel eines explosionsgeschützten Gehäuses 10 gemäß einer Ausführungsform der erfindungsgemäßen Lehre. Das Gehäuse 10 weist ein wannen- oder behälterförmiges, beispielsweise quaderförmiges oder zylindrisches, erstes Gehäuseteil 11 auf, welches eine Wand 12 aufweist. Die Wand 12 weist einen ersten Wandabschnitt (eines erster Abschnitts 13) auf. Das Gehäuseteil 11 umschließt einen Innenraum 14 des Gehäuses 10 in Umfangsrichtung, um den Innenraum 14 von der Umgebung 15 des Gehäuses 10 abzugrenzen. Der Innenraum 14 kann dazu bestimmt sein, in dem Innenraum 14 elektrische oder elektronische Komponenten 16 anzuordnen, welche Zündquellen bilden können. Das erste Gehäuseteil 11 legt eine Öffnung 17 fest. Die Öffnung 17 ist mit einem deckelförmigen zweiten Gehäuseteil 18 geschlossen, welches eine Wand des Gehäuses 10 und somit einen zweiten Wandabschnitt (einen zweiten Abschnitt 20) bildet. Das zweite Gehäuseteil 18 kann, je nach Verwendung des Gehäuses 10, beispielsweise eine Rückwand, eine Vorderwand, eine Seitenwand oder einen Deckel des Gehäuses 10 bilden.

Das erste Gehäuseteil 11 kann aus Blechmaterial gefertigt sein. Das Material des ersten Gehäuseteils 11 ist bevorzugt frei von zünddurchschlagsicheren offenen Poren oder Spalten, welche den Innenraum 14 des Gehäuses 10 mit der Umgebung 15 verbinden würden. An dem ersten Gehäuseteil 11 kann aber eine äußere Druckentlastungsvorrichtung 21 mit einem offenporigen Druckentlastungskörper 20 angeordnet sein und/oder in dem Gehäuse 10 kann eine innere Druckentlastungsvorrichtung 23 angeordnet sein.

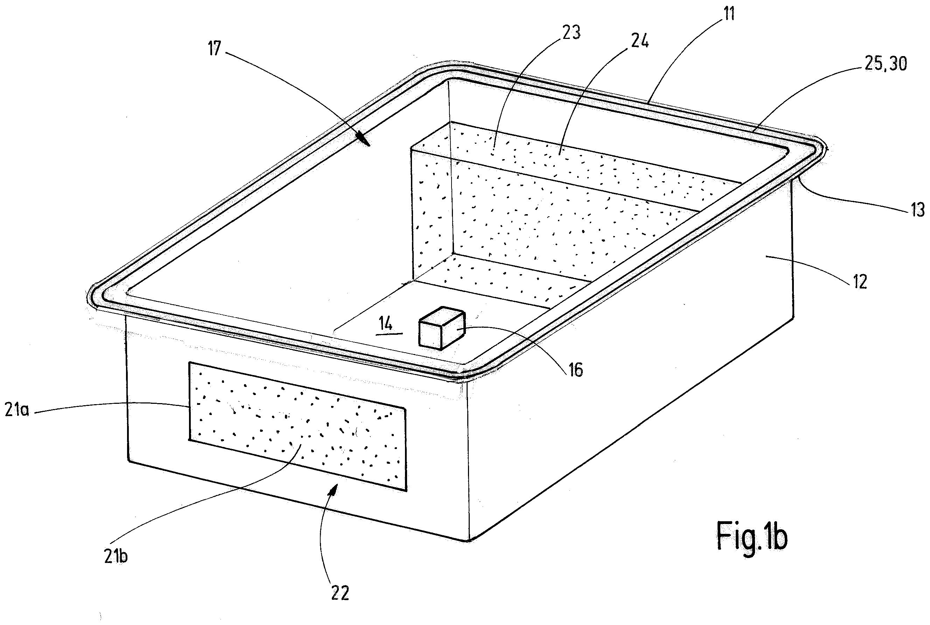

Die innere Druckentlastungsvorrichtung 23 kann, wie sich aus Figur 1b ergibt, im Innenraum 14, insbesondere an einer Wandseite oder mehreren Wandseiten, des ersten Gehäuseteils 11 angeordnet sein. Die innere Druckentlastungsvorrichtung 23 weist poröses Material 24 auf. Dies kann beispielsweise eine Schüttung von losem partikularem Material sein und/oder ein offenporiger Körper, beispielsweise ein Kunststoff oder Metallschaum, ein Wirrfaserkörper, ein Körper aus einer oder mehreren Gitterlagen, wobei jede Gitterlage gewebt, gelegt oder auf andere Weise gefertigt sein kann. Die innere Druckentlastungsvorrichtung 23 dient dazu, im Falle einer Explosion Wärme oder Bewegungsenergie aus dem Explosionsgas aufzunehmen, um damit den Spitzendruck, welcher ohne die innere Druckentlastungsvorrichtung 23 in dem Gehäuse 10 auftreten würde, zu senken. Die innere Druckentlastungsvorrichtung 23 zeichnet sich dadurch aus, dass diese den Spitzendruck zu senken vermag, ohne Gas aus dem Innenraum 14 des Gehäuses 10 herauszulassen.

An der Wand des ersten Gehäuseteils 11, welche eine Drückentlastungsöffnung 21a aufweist, kann eine Druckentlastungskörper 21b angeordnet sein, der die Öffnung 21a zünddurchschlagsicher verschließt. Die Öffnung 21a und der Druckentlastungskörper 21b bilden eine äußere Druckentlastungsvorrichtung 22. Die äußere Druckentlastungsvorrichtung 22 weist einen Druckentlastungskörper 22 auf, welcher offene Poren aufweist, die einen Gasaustausch zwischen dem Innenraum 14 des Gehäuses 10 und der Umgebung 15 des Gehäuses 10 prinzipiell zulassen, wobei die Poren jedoch Spalte mit einer maximalen Spaltweite und minimalen Spaltlänge bilden, so dass heißes Gas und/oder Partikel aus dem Innenraum 15 des Gehäuses 10 den Druckentlastungskörper 22 zur Umgebung 15 des Gehäuses 10 nur derart abgekühlt verlassen können, so dass diese zündfähige Atmosphäre in der Umgebung 15 des Gehäuses 10 nicht entzünden können. Der Druckentlastungskörper 22 ist beispielsweise durch Eingießen, Kleben, Löten, Schweißen, Klemmen oder dergleichen derart mit der Wand 12 verbunden, dass heißes Gas und/oder Partikel den Druckentlastungskörper auch nicht umgehen können, zumindest nicht, ohne derart abgekühlt zu sein, dass diese eine explosionsfähige Atmosphäre in der Umgebung 15 des Gehäuses 10 entzünden könnten.

Die innere Druckentlastungsvorrichtung 23 und die äußere Druckentlastungsvorrichtung 22 können an einer Seite des Gehäuses 10 angeordnet sein, so dass das Gas zunächst durch die innere Druckentlastungsvorrichtung 23 strömt, um dann durch die äußere Druckentlastungsvorrichtung 22 in die Umgebung 15 des Gehäuses 10 zu strömen.

Die innere Druckentlastungsvorrichtung 23 und/oder die äußere Druckentlastungsvorrichtung 22 sorgen vorzugsweise für eine Reduzierung des Spitzendrucks für den Auslegungsfall des Gehäuses 10 auf einen Überdruck von kleiner oder gleich 1000 mbar oder, bevorzugt kleiner oder gleich 500 mbar.

Die Wand 12 des ersten Gehäuseteils 11, welche den Innenraum 14 des Gehäuses 10 von oben, von unten und/oder von der Seite flächig begrenzt, weist als ersten Abschnitt 13 einen quer beispielsweise senkrecht nach außen (wie dargestellt) und/oder (abschnittsweise) nach innen auskragenden Abschnitt 13 auf, welcher einen Flanschabschnitt bildet. Der Flanschabschnitt 13 umgibt die Öffnung 17. Der Flanschabschnitt 13 kann in Umfangsrichtung geschlossen sein. Der Flanschabschnitt 13 weist eine Sicke 25 auf. Deren Boden 26 kann zu der der Öffnung 17 gegenüberliegenden Seite des ersten Gehäuseteils 11 vorstehen oder in entgegengesetzte Richtung. Die Sicke 25 umgibt die Öffnung 17 bevorzugt umfänglich geschlossen.

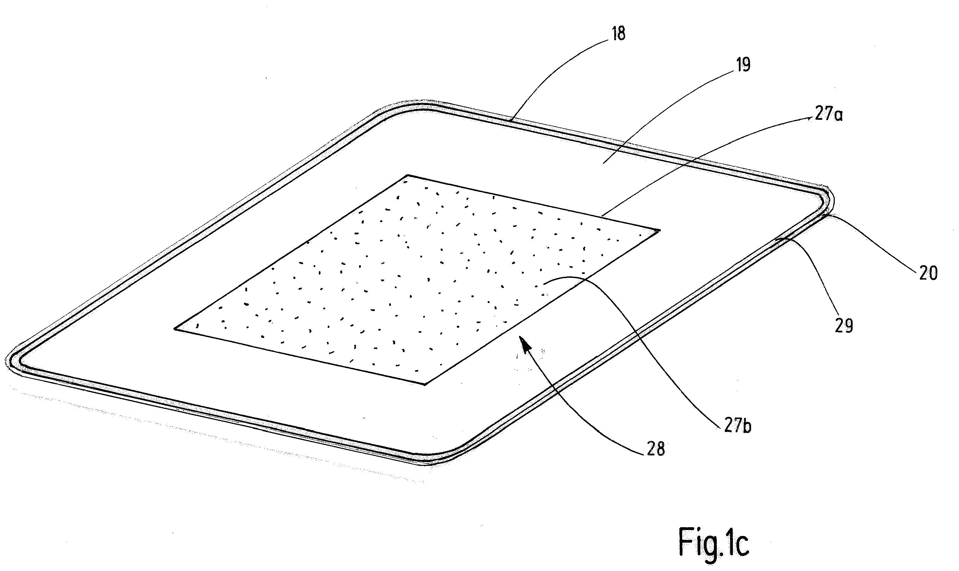

Das Material des zweiten Gehäuseteils 18, bevorzugt Blech, ist vorzugsweise frei von zünddurchschlagsicheren offenen Poren oder Spalten, welche den Innenraum 14 des Gehäuses 10 mit der Umgebung 15 fluidisch verbinden würden. Wie sich aus Figur 1c ergibt, kann das Gehäuse 10 zusätzlich oder alternativ zu der inneren Druckentlastungsvorrichtung 23 und/oder der äußeren Druckentlastungsvorrichtung 22, welche von dem ersten Gehäuseteil 11 getragen werden, eine weitere Druckentlastungsöffnung 27a und eine weiteren äußeren Druckentlastungskörper 27b, welche eine weitere äußere Druckentlastungsvorrichtung 28 bilden, und/oder weitere innere Druckentlastungsvorrichtung (nicht dargestellt) halten. Diese können beispielsweise wie oben im Zusammenhang mit der inneren und/oder äußeren Druckentlastungsvorrichtung 23, 22 des ersten Gehäuseteils 11 ausgebildet sein und demselben Zweck dienen. Zu der äußeren Druckentlastungsvorrichtung 28 gehört eine Druckentlastungsöffnung 27a in dem zweiten Gehäuseteil 18, welche mit einem Druckentlastungskörper 27b zünddurchschlagsicher, aber gasdurchlässig verschlossen ist.

Das erste Gehäuseteil 11 und das zweite Gehäuseteil 18 können aus beispielsweise aus Stahlblech oder Aluminiumblech sein. Alternativ können das erste Gehäuseteil 11 und/oder das zweite Gehäuseteil 18 aus Kunststoff sein. Bevorzugt sind der Randabschnitt 20 und/oder der Flanschabschnitt 13 Blechabschnitte. Die Dicke, beispielsweise Blechstärke, des Flanschabschnitts 13 und/oder des Randabschnitts 20 kann kleiner oder gleich 5mm, kleiner oder gleich 3mm, oder kleiner oder gleich 2mm sein. Das Gehäuse 10 kann solche geringen Wandstärken ohne weitere Maßnahmen zur Stabilisierung auf Grund der äußeren Druckentlastungsvorrichtung 22, 28 und/oder inneren Druckentlastungsvorrichtung 23 haben, welche den Explosionsdruck so stark begrenzt, dass sogar ein Gehäuse 10 aus einem Metall- und/oder Kunststoffmaterial mit Blechstärke dem Explosionsdruck wiederstehen kann.

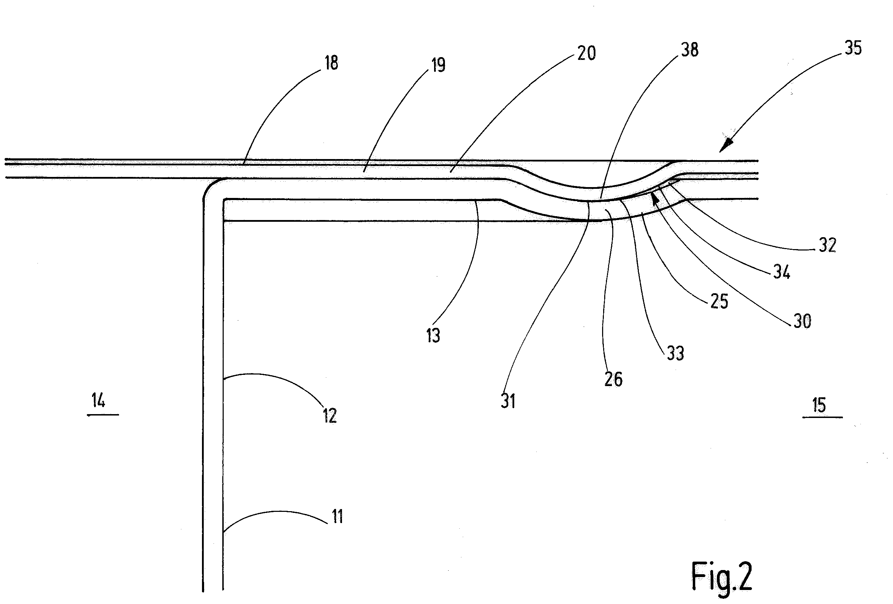

Wie sich weiter aus Figur 1c ergibt, weist das zweite Gehäuseteil 18 im Randabschnitt 20, welcher den zweiten Wandabschnitt des zweiten Gehäuseteils 18 bildet, eine weitere, in Umfangsrichtung geschlossene Sicke 29 auf. Die Sicke 25 und die weitere Sicke 29 bilden, wie aus Figur 2 hervorgeht, ein Aufnahme-Rücken-Paar. Wobei die Vorwölbung, hier gebildet durch den Boden der weiteren Sicke 29, in einer Aufnahme 30, gebildet durch die Sicke 25 des ersten Gehäuseteils 11, aufgenommen ist.

Figur 2 zeigt das erste Gehäuseteil 11 und das zweite Gehäuseteil in Anlage im miteinander unverspannten Zustand. Auch in Figur 1a ist das Gehäuse 10 in diesem Zustand ohne Verspannvorrichtung dargestellt. Wie sich aus Figur 2 weiter ergibt, ist für den ersten Abschnitt 13 und für den zweiten Abschnitt 20 ein Abstützbereich 31 festgelegt, in welchem sich der Randabschnitt 20 des zweiten Gehäuseteils 18 an dem Flanschabschnitt 13 des ersten Gehäuseteils 11 abstützt, wenn das zweite Gehäuseteil 18 an das erste Gehäuseteil 11 gelegt ist (wie in Figur 1a und Figur 2 gezeigt), ohne dass das erste Gehäuseteil 11 und das zweite Gehäuseteil 18 wie bei dem Gehäuse 10 im zünddurchschlagsicheren Zustand miteinander verspannt sind. Wie Figur 2 veranschaulicht, sind die Formen des Randabschnitts 20 und des Flanschabschnitts 13 nicht miteinander komplementär. Vielmehr öffnet sich von dem Abstützbereich 31 weg ein spaltförmiger Zwischenbereich 32 in Richtung weg von dem Abstützbereich 31. Der Zwischenbereich 32 wird von gegenüberliegenden ersten Fläche 33 des ersten Abschnitts 13 und zweiten Fläche 34 des zweiten Abschnitts 20 begrenzt. In einem Verspannbereich 35, welcher auch als Krafteinleitungs- oder Drückbereich bezeichnet werden könnte und welcher für den Flanschabschnitt 13 und den Randabschnitt 20 festgelegt ist, sind das Blechmaterial des ersten Gehäuseteils 11 und das Blechmaterial des zweiten Gehäuseteils 18 voneinander beabstandet. Der Zwischenbereich 32 bildet eine Trennstelle des Gehäuses 10.

Es sei an dieser Stelle bemerkt, dass der Zwischenbereich 32 ganz oder teilweise gefüllt oder frei sein kann. Der ganz oder teilweise gefüllte Zwischenbereich 32 kann beispielsweise mit einem Kunststoffelement gefüllt sein.

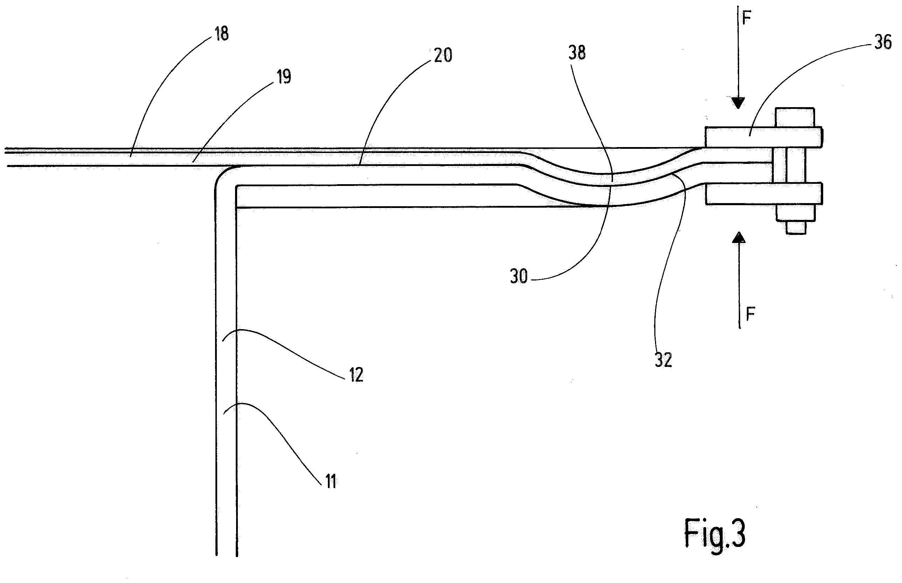

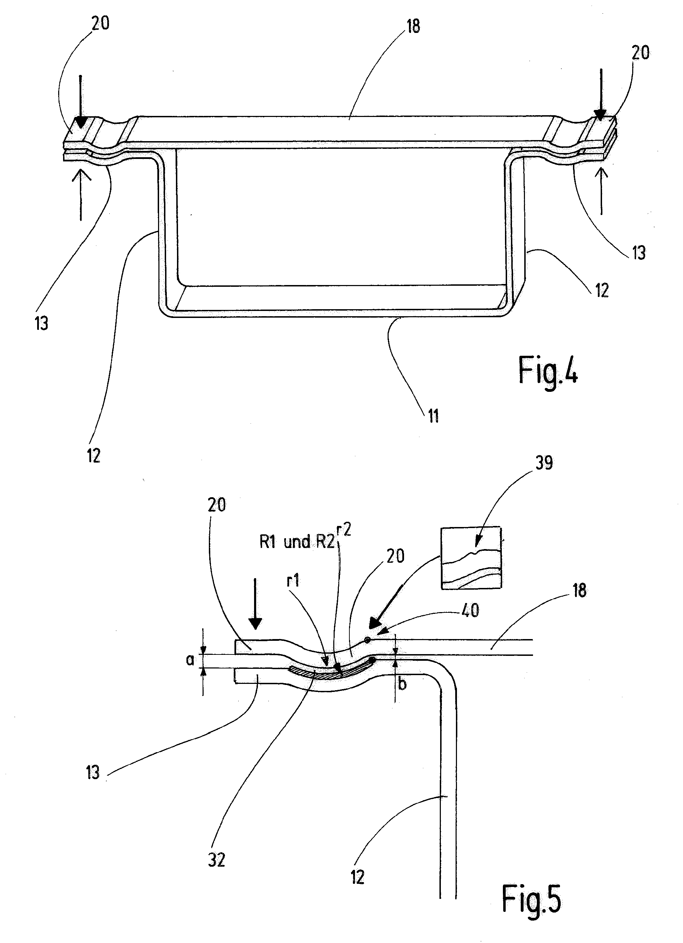

Ohne dass der Randabschnitt 20 des zweiten Gehäuseteils 18 und der Flanschabschnitt 13 des ersten Gehäuseteils 11 miteinander verspannt wären, weist der Zwischenbereich 32 trotz Anlage noch keine Geometrie, insbesondere Länge und/oder maximale Weite auf, so dass dieser zünddurchschlagsicher wäre. Um die Öffnung 17 mit dem zweiten Gehäuseteil 18 zünddurchschlagsicher zu schließen, müssen Randabschnitt 20 und Flanschabschnitt 13 miteinander verspannt werden. Dazu dient eine Verspannvorrichtung 36, wie sie beispielhaft in Figur 3 gezeigt ist. In Figur ist ein Ausschnitt des Gehäuses gemäß Figur 1a gezeigt. Aus Figur 4 ergibt sich, dass durch die Verspannvorrichtung 36 Randbereiche als Verspannbereiche des Randabschnitts 20 und des Flanschabschnitts 13 gegeneinander gedrückt werden, um den Zwischenbereich 32 zünddurchschlagsicher zu schließen. Auf Grund der geringen Materialdicke des Randabschnitts 20 und des Flanschabschnitts 13 reichen zur Verspannung bereits geringe Kräfte aus, um den Randabschnitt 20 und den Flanschabschnitt 13 so zu verformen, dass der Zwischenbereich 32 von der Verformung des Flanschabschnitts 13 und/oder des Randabschnitts 20 verengt wird, so dass der Zwischenbereich 32 im verspannten Zustand eine Spaltgeometrie hat, die zünddurchschlagsicher ist. Von der Verformung des Randabschnitts 20 und/oder der Verformung des Flanschabschnitts 13 kann ein 0-Ex Spalt (explosionsgeschützter Spalt der Spaltweite 0) gebildet werden.

Figur 5 ist eine nähere Veranschaulichung beispielhafter geometrischer Verhältnisse bei dem erfindungsgemäßen Gehäuse 10. Wenn das zweite Gehäuseteil 18 (vorzugsweise ein Blechteil) und das erste Gehäuseteil 11 (vorzugsweise ein Blechteil) in Anlage gebracht, aber noch nicht verspannt sind, kann der Abstand b zwischen dem Blechabschnitt des ersten Gehäuseteils 11 und dem Blechabschnitt des zweiten Gehäuseteils 18 in dem Zwischenbereich 32 und dem Innenraum 14 des Gehäuses 10 im Abstützbereich gleich 0 oder stellenweise größer 0 sein. Ein Abstand b größer Null kann entlang des Randes des ersten Gehäuseteils 11 stellenweise auf Grund einer vorbestimmten Form des zweiten Gehäuseteils 18 vorhanden sein, die von der Form des ersten Gehäuseteils 18 abweicht.

Weg von dem Abstützbereich 31 kann sich der Zwischenbereich 32 bis auf eine Weite a vergrößern (a größer b). Der Radius des runden Rückens 38, welchen der Randabschnitt 20 ausbildet, kann r1 betragen, wobei der Radius der Aufnahme 30 beispielsweise r2 betragen kann und r1 kleiner r2 ist. Durch das Verspannen des ersten Gehäuseteil 11 und des zweiten Gehäuseteil 18 miteinander durch Krafteinleitung in einen von dem Abstützbereich 31 entfernten Einleitungsbereich 35 werden die Formen, insbesondere Radien des Randabschnitts 20 und des Flanschabschnitts 13 aneinander angepasst. Sie müssen danach nicht übereinstimmen, jedoch sind die Radien r1, r2 beispielsweise aneinander angeglichen, ohne zwingend gleich sein zu müssen. In Ausführungsformen können die Radien r1, r2 angeglichen werden, so dass diese im verspannten Zustand gleich sind.

Das erste Gehäuseteil 11 und/oder das zweite Gehäuseteil 18 kann eine Einrichtung 39 aufweisen, um eine Biegezone 40 des ersten Gehäuseteils 11 und/oder des zweiten Gehäuseteils 18 zu definieren. In dem in Figur 5 dargestellten Ausführungsbeispiel besteht die Einrichtung 39 beispielsweise in einer Ausnehmung in dem zweiten Gehäuseteil am Rande der Sicke 29. Die rinnenförmige Ausnehmung 39 kann sich in Umfangsrichtung geschlossen oder unterbrochen entlang der Sicke 29 erstrecken, beispielsweise entlang einer geraden Linie. Eine höhere Nachgiebigkeit in der Biegezone 40 kann alternativ oder zusätzlich zu einer geringeren Wandstärke durch eine Ausnehmung durch beispielsweise eine Gefügeveränderung in einem Bereich des Blechmaterials festgelegt sein (nicht dargestellt). Insbesondere wenn eine Einrichtung 39 zur Festlegung einer Biegezone 40 in dem zweiten Abschnitt 20 und/oder dem ersten Abschnitt 13 vorhanden ist, können die Formveränderungen beim Verspannen besonders genau vorherbestimmt sein. Das Material, insbesondere Blechmaterial, des ersten Abschnitts 13 und/oder des zweiten Abschnitts 20 kann mit einer solchen Einrichtung 39 gezielter einerseits stark genug ausgebildet sein, um einer Explosion standhalten zu können und andererseits biegsam genug, um den Kraftaufwand zum Verformen zur Ausbildung des zünddurchschlagsicheren Zwischenbereichs 32 klein zu halten.

In Figur 5 ist mit dickerem Strich der Bereich markiert, welcher beim Verspannen derart geschlossen wird, dass dieser die Anforderungen an einen Ex-Spalt einhält.

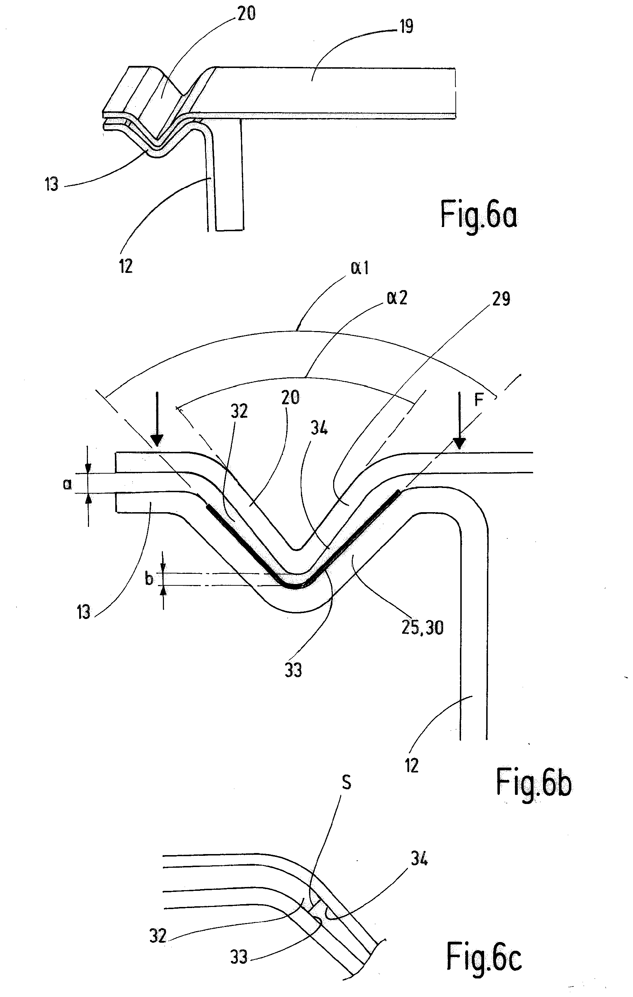

Figuren 6a und 6b veranschaulichen ein weiteres Ausführungsbeispiel der Erfindung. Die Form und/oder Lage der ersten Fläche 33 des ersten Abschnitts 13 und die Form und/oder Lage der zweiten Fläche 34 des zweiten Abschnitts 20 sind dazu bestimmt, einen Zwischenbereich 32 zu bilden - wenn das erste Gehäuseteil 11 und das zweite Gehäuseteil 18 zusammengesetzt sind, um das Gehäuse 10 zu schließen. Der Zwischenbereich 32 weist ohne ausreichende Verspannung des ersten Gehäuseteils 11 und des zweiten Gehäuseteils 18 ein Spaltmaß außerhalb des zünddurchschlagsicheren Bereichs auf. Das erste Gehäuseteil 11 und das zweite Gehäuseteil 18 sind folglich dazu eingerichtet und bestimmt, wenn diese wie vorbestimmt zusammengesetzt sind, aber nicht verspannt sind, einen Zwischenraum in der Trennstelle zu begrenzen, welcher erst auf Grund der Verspannung und der dadurch hervorgerufenen Verformung von dem erstem Gehäuseteil 11 und/oder dem zweitem Gehäuseteil 18 zünddurchschlagsichere Spaltmaße annimmt. In dem in Figur 6a, 6b, 6c dargestellten Ausführungsbeispiel sind die Sicken V-förmig. Die Figuren zeigen ein weiteres Beispiel, in welchem der verformte erste Abschnitt 13 und/oder der verformte zweite Abschnitt 20 einen Knick und/oder eine Krümmung 25, 29 aufweisen.

Der Knick und/oder die Krümmung 25, 29 bildet vorzugsweise eine langgestreckte Nutform, welche sich quer zur relevanten (effektive) Länge des Zwischenbereichs 32 erstreckt. Die relevante Länge des Zwischenbereichs 32 wird vom Eingang des Zwischenbereichs 32 zum Ausgang des Zwischenbereichs 32 gemessen. Die in gerader Richtung gemessene Länge des Zwischenbereichs 32 vom Eingang des Zwischenbereichs 32 zum Ausgang des Zwischenbereichs 32 kann mit dem Knick oder der Krümmung viel kürzer sein, als die effektive Länge des Zwischenbereichs 32. Die effektive Länge des Zwischenbereichs 32 bestimmt die Zünddurchschlagsfestigkeit oder Zünddurchschlagsicherheit des Zwischenbereichs 32. Dabei wird davon ausgegangen, dass, wenn das Gas einen der effektiven Länge entsprechenden Weg durch den Zwischenbereich 32 nimmt, dieses soweit abgekühlt ist, dass es eine Explosion am Ausgang des Zwischenbereichs 32 nicht mehr auslösen kann.

Kleine Wandstärken machen den Einsatz von Blechkonstruktionen und Blechtechniken möglich. Durch Formgebung an Blechelementen können durch bekannte Blechumformverfahren, z.B. Tiefziehen, Metalldrücken, Rollen, Sicken, Biegen, Hochdruckformen, Streckziehen, Drücken, Ziehen, Laserstrahlbiegen usw. Blechpaare als erste und zweite Abschnitte bilden, welche im elastischen Bereich des Bleches verformbar sein und welche eine blechgeformte Spaltgeometrie des Zwischenbereichs begrenzen. Die beiden den Zwischenbereich begrenzenden Blechabschnitte können durch das Verspannen derart verformt werden, dass der Zwischenbereich zu einem Ex-Spalt geschlossen wird. Dies bedeutet nicht, dass der Zwischenbereich gasdicht, jedoch dass keine Gase oder Partikel den Zwischenbereich derart heiß verlassen können, dass diese eine Atmosphäre außerhalb des Gehäuses 10 entzünden können.

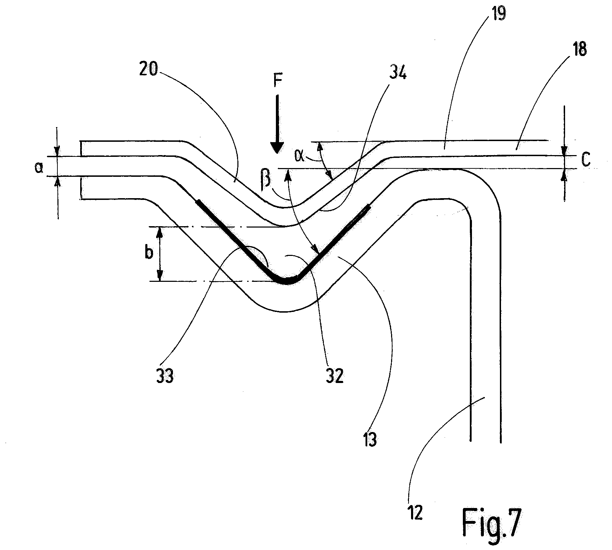

Die Figuren 6a bis 6c und 7 zeigen Ausführungsbeispiele, bei denen das erste Gehäuseteil 11 und das zweite Gehäuseteil 18 zueinander nicht komplementäre V-formen aufweisen, so dass die blechgeformte Spaltgeometrie ebenfalls V-förmig ist. Die Wandfläche 33 des Blechabschnitts 13 des ersten Gehäuseteils 11 und des Blechabschnitts 20 des zweiten Gehäuseteils 18, welche einander gegenüberliegen und zwischen sich den Zwischenbereich 32 begrenzen, schließen unterschiedliche Winkel α1, α2 ein. Im Ausführungsbeispiel gemäß Figur 6a und 6b ist die Außenfläche 34 des rückenförmigen Abschnitts 20 des zweiten Gehäuseteils 18 im Querschnitt V-förmig und legt einen kleineren Öffnungswinkel α2 fest, als die Wandfläche 33 des Blechabschnitts 13 des ersten Gehäuseteils 11, welches die langgestreckte Aufnahme 30 begrenzt. Dadurch wird ein Abstützbereich 31 am Boden der langgestreckten Aufnahme 30 definiert. An den freien Enden der Blechabschnitte 13, 20 ist der Abstand zwischen dem ersten Gehäuseteil (Abstand a) größer (in der unverspannten Anlage) als im Abstützbereich 31. Der Zwischenbereich 32 öffnet sich daher zunehmend nach außen. Im Abstützbereich 31 kann der Abstand (b) beispielsweise 0 oder, falls ein Zwischenelement zwischen dem Blechabschnitt 13 des ersten Gehäuseteils 11 und dem Blechabschnitt 20 des zweiten Gehäuseteils 18 angeordnet ist, größer 0 sein. Auch kann der Abstand im unverspannten Zustand stellenweise größer 0 sein, wenn das erste Gehäuseteil 11 und das zweite Gehäuseteil 18 aufgrund grober Herstellungstoleranzen im unverspannten Zustand nur punktuell anliegen.

Der Öffnungswinkel α1 der aufnehmenden Sicke 25 ist größer als der Öffnungswinkel α2, den die Fläche 34 des Blechabschnitts 20 des zweiten Blechteils 18 definiert, die dem ersten Blechteil 11 zugewandt ist. Wie durch die Pfeile angedeutet, sind Krafteinleitungsbereiche innerhalb und außerhalb des durch den Zwischenbereich 32 definierten Umfang festgelegt. Wobei Unterabschnitte der Blechabschnitte 13, 20 in entgegengesetzte Richtung gegen den Gegenabschnitt 13, 20 gedrückt werden. Unverspannte Anlage bzw. unverspannter Zustand bedeutet, dass der erste Abschnitt 13 und der zweite Abschnitt 20 noch nicht den Zwischenbereich 32 zünddurchschlagsicher schließend gegeneinandergedrückt sind.

Wie in Figur 6b erkennbar ist die Blechdicke des ersten Gehäuseteils 11 größer als die Blechdicke des zweiten Gehäuseteils 18. Beim Verspannen passen sich die Formen der Sicken aneinander an, so dass der Unterschied in den Winkeln α1, α2 der zueinander weisenden Flächen 33, 34 des ersten Blechteils 11 und des zweiten Blechteils 18 im verspannten Zustand kleiner ist als im nichtverspannten Zustand. Auf Grund der unterschiedlichen Blechdicken, woraus sich eine unterschiedliche Nachgiebigkeit ergibt, trägt legen Bereiche des zweiten Abschnitts 20 des zweiten Gehäuseteils 18 im Vergleich zu den Bereichen des ersten Abschnitts 13 des ersten Gehäuseteils 11 einen größeren Abschnitt der Strecke S zurück, welche zum zünddurchschlagsicheren Verformen zurückzulegen ist.

Die Strecke S, welche das erste Gehäuseteil 11 und das zweite Gehäuseteil 18 zumindest teilweise aufeinander zu zurücklegen müssen, um den Zwischenbereich 32 auf Null oder zumindest so weit zu schließen, dass Zünddurchschlagsicherheit hergestellt ist, ist in Figur 6c veranschaulicht. Die Strecke S kann auf Grund der Blechdicke, des Materials, des Gefüges, der Form und/oder anderer Eigenschaften überwiegend (zu mehr als die Hälfte) von dem zweiten Gehäuseteil 18 oder dem ersten Gehäuseteil 11 zurückgelegt werden, je nach dem welches Gehäuseteil 11, 18 entsprechend nachgiebiger ist.

Vom Boden der Aufnahme 30 nach innen weg öffnet sich der Zwischenbereich 32 aufgrund der unterschiedlichen Öffnungswinkel α1, α2 zunehmend nach innen. Innerhalb des durch die Aufnahme 30 und/oder den Zwischenbereich 32 definierten Umfangs kann der Abstand c des Blechabschnitts 13 des ersten Gehäuseteils 11 und des zweiten Gehäuseteils 18 etwa gleich dem Abstand a sein (bei Anlage und im unverspannten Zustand).

In dem Ausführungsbeispiel gemäß Figur 7 weist schließt die Fläche 34 des Rückenbereichs des Blechabschnitts 20 des zweiten Gehäuseteil 18 einen größeren Öffnungswinkel α2 ein als die gegenüberliegende Fläche 33 des Blechabschnitts 13 des ersten Gehäuseteils 11. Der Abstand b zwischen der Spitze des Rückens und dem Boden 26 der langgestreckten Ausnehmung 25 ist größer als der Abstand a, c des Blechabschnitts 13 des ersten Gehäuseteils 11 und des Blechabschnitts 20 des zweiten Gehäuseteils 18 innerhalb und/oder außerhalb des Umfangs, welcher durch die Spitze des Rückens 38 festgelegt ist. Es gilt vorzugsweise b > a und a > c.

Die Pfeile in den Figuren 6a, 6b und 7 verdeutlichen Beispiele möglicher Kraftangriffsstellen zum Verspannen des ersten Gehäuseteils 11 und des zweiten Gehäuseteils 18, so dass der Zwischenbereich 32 zwischen den Blechabschnitt 13 des ersten Gehäuseteils 11 und dem Blechabschnitt 20 des zweiten Gehäuseteils 18 von der Verspannung und der damit einhergehenden elastischen Verformung des Blechabschnitts 13 des ersten Gehäuseteils 11 und des Blechabschnitts 13 des zweiten Gehäuseteils 20 zünddurchschlagsicher geschlossen wird.

In Ausführungsformen gemäß Figur 7 öffnet sich im unverspannten Zustand, aber bei zum Verspannen geeigneter Anlage von zweitem Gehäuseteil 18 und erstem Gehäuseteil 11, der Zwischenbereich 32 zunehmend von innen nach außen zum Boden 26 der Aufnahme 25 und von außen nach innen zum Boden 26 der Aufnahme 25. Die Strecke S zum Schließen des Zwischenbereichs 32 so, dass dieser zünddurchschlagsicher ist, wird auf Grund der geringeren Dicke des Materials des zweiten Gehäuseteils 18 überwiegend von dem Rahmenabschnitt 20 des zweiten Gehäuseteils 18 zurückgelegt, welches auf Grund der geringeren Dicke nachgiebiger ist, als der Flanschabschnitt 13.

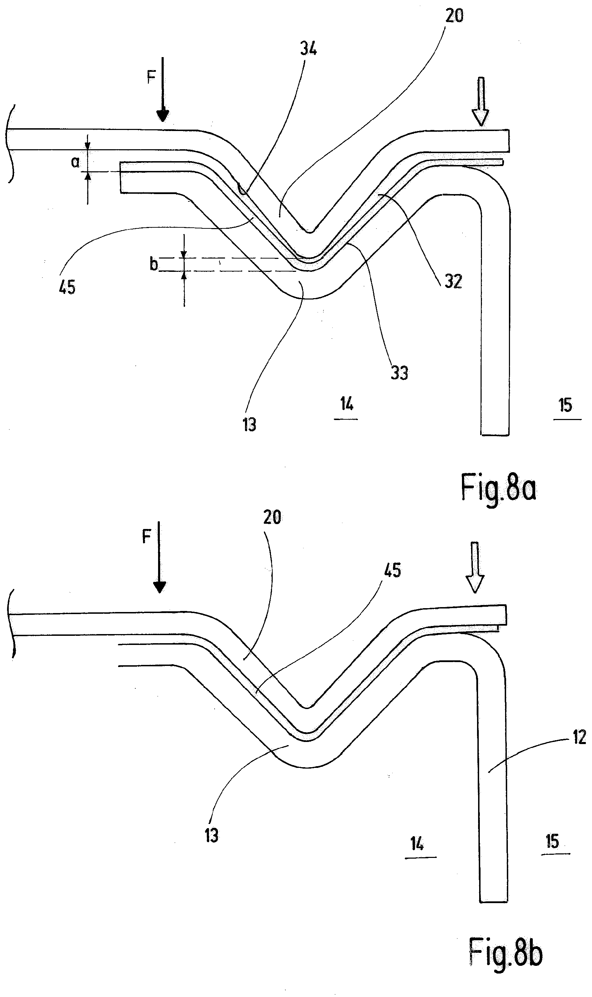

Die Figur 8a bis 8b zeigt ein Ausführungsbeispiel mit einem ersten Gehäuseteil 11 und einem Flanschabschnitt 13, der ein nach innen auskragender Abschnitt des ersten Gehäuseteils 11 ist. Der Flanschabschnitt 13 bildet eine langgestreckte Ausnehmung 30, welche beispielsweise V- oder U-förmig sein kann. Das zweite Gehäuseteil 18 bildet einen Rücken 38, welcher im unverspannten Zustand und erst recht im verspannten Zustand in der Ausnehmung 30 angeordnet ist, wenn das erste Gehäuseteil 11 und das zweite Gehäuseteil 18 aneinander anliegen, um verspannt zu werden oder im verspannten Zustand. Zwischen dem Blechabschnitt 13 des ersten Gehäuseteils 11 und dem Blechabschnitt 20 des zweiten Gehäuseteils 18 ist ein Zwischenrahmen 45 angeordnet, so dass der erste Abschnitt 13 des ersten Gehäuseteils 11 und der zweite Abschnitt 20 des zweiten Gehäuseteils 18 nicht direkt sondern vermittelt über den Zwischenrahmen 45 aneinander anliegen. Der Zwischenrahmen 45 ist ein von dem ersten Gehäuseteil 11 und dem zweiten Gehäuseteil 18 gesondertes Teil, kann aber mit dem ersten Gehäuseteil 11 oder dem zweiten Gehäuseteil 18 verbunden, insbesondere verklebt sein. Der Zwischenrahmen 45 kann aus Kunststoff sein, während das erste Gehäuseteil 11 und das zweite Gehäuseteil 18 aus dem gleichen Kunststoff, aus einem anderen Kunststoff oder aus Metall sein können. Die elastische Verformbarkeit des Zwischenrahmens 45 kann größer sein als die Verformbarkeit des Blechabschnitts 13 des ersten Gehäuseteils 11 und des zweiten Gehäuseteils 18, welche einander gegenüberliegen. Werden der Blechabschnitt 13 des ersten Gehäuseteils 11 und der Blechabschnitt 20 des zweiten Gehäuseteils 18 miteinander verspannt, so nähern sich die Form des ersten Blechabschnitts 13 des ersten Gehäuseteils 11 und die Form des zweiten Blechabschnitts 20 des zweiten Gehäuseteils 18 relativ zueinander aneinander durch elastische Verformung des ersten Gehäuseteils 11 und/oder des Blechabschnitts 20 des zweiten Gehäuseteils 18 an. Auch im verspannten Zustand muss die Form des Blechabschnitts 13 des ersten Gehäuseteils 11 und des Blechabschnitts 20 des zweiten Gehäuseteils 18 nicht notwendigerweise komplementär sein. Der elastisch nachgiebige Zwischenrahmen 45 kann das zünddurchschlagsichere Verschließen von der Verformung des zweiten Abschnitts 20 und/oder des ersten Abschnitts 13 unterstützen, indem die Verformung des Zwischenrahmens 45 Zwischenräume ausfüllt und so zu einem insgesamt zünddurchschlagsicheren Zwischenbereich 32 beiträgt.

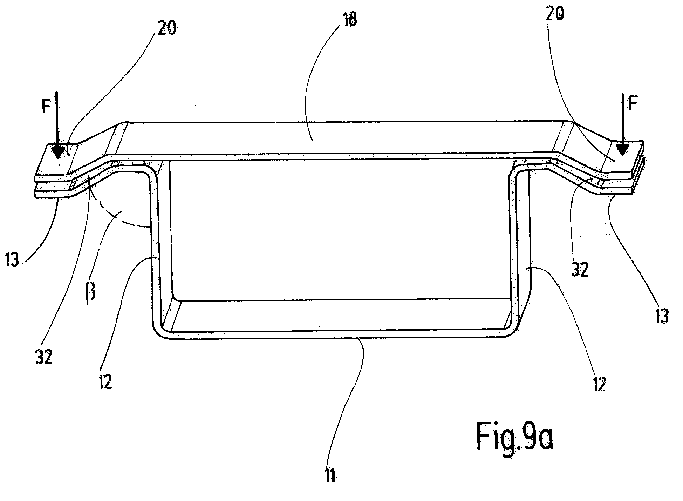

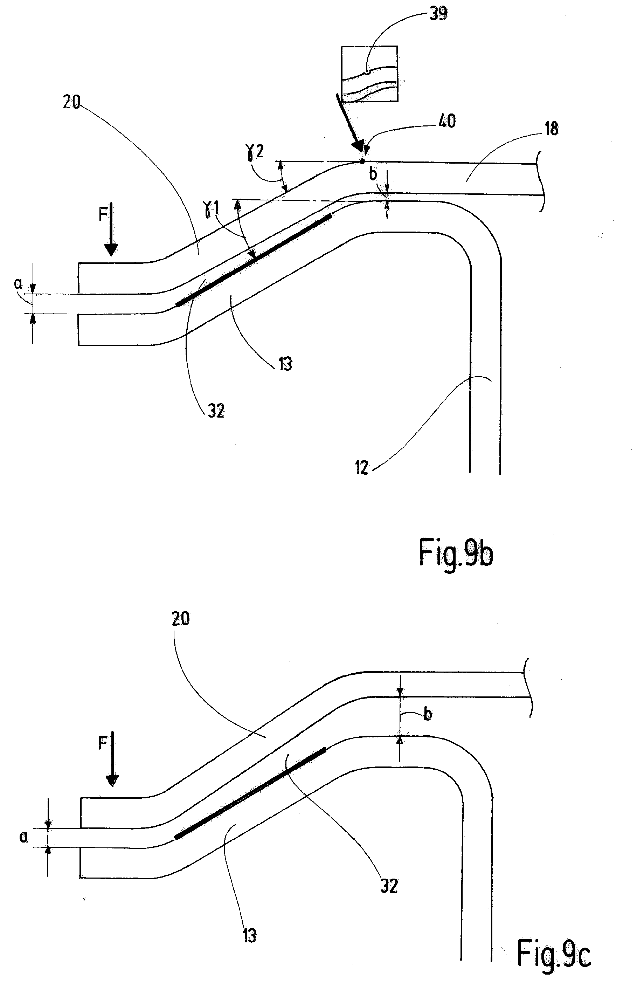

In den Figuren 9a und 9b ist ein weiteres Ausführungsbeispiel von im unverspanntem Zustand bei Anlage nicht zueinander komplementärer Sollformen von Blechabschnitten 13, 20 eines ersten Gehäuseteils 11 und eines zweiten Gehäuseteils 18 eines erfindungsgemäßen Gehäuses 10 dargestellt. Figur 9a zeigt einen Ausschnitt eines explosionsgeschützten erfindungsgemäßen Gehäuses 10 zwischen zwei parallelen Schnittebenen. Zumindest ein Unterabschnitt des Blechabschnitts 13 des ersten Gehäuseteils 11 und zumindest ein Unterabschnitt des Blechabschnitts 20 des zweiten Gehäuseteils 18 schließen mit der Wand 12 des Gehäuses 10 einen Winkel β kleiner 90° ein. Das freie Ende des Blechabschnitts 13 des ersten Gehäuseteils 11 und des Blechabschnitts 20 des zweiten Gehäuseteils 18, welche Biegefedern bilden, um zwischen diesen beim Verspannen einen Zwischenbereich 32 zünddurchschlagsicher zu schließen, ist zwischen der Öffnungsebene und der gegenüberliegenden rückseitigen oder Bodenebene des Gehäuses 10 angeordnet.

Das Ausführungsbeispiel gemäß Figuren 9a, 9b kommt ohne muldenförmige und/oder langgezogene Vertiefung 30 und entsprechende Vorwölbungen 38, welche beispielsweise rückenförmig sein können, aus. Es sind jedoch Abwandlungen des Ausführungsbeispiels gemäß Figuren 9a, 9b möglich, in denen in dem ersten Blechabschnitt 13 und/oder dem zweiten Blechabschnitt 20 eine Ausnehmung 30, insbesondere Mulde und/oder langgestreckte Ausnehmung ausgebildet ist, in welche eine Vorwölbung 38, insbesondere ein Rücken, des anderen Blechabschnitts 20 angeordnet ist. Während Beispiele gezeigt sind, in denen das erste Gehäuseteil 11 die Aufnahme 30 bildet und das zweite Gehäuseteil 18 den Rücken kann zusätzlich oder alternativ das erste Gehäuseteil 11 den Rücken 38 und das zweite Gehäuseteil 18 die Aufnahme 30 bilden.

In dem in Figur 9a, 9b dargestellten Ausführungsbeispiel öffnet sich bei Anlage (Abstand b größer oder gleich 0) des zweiten Gehäuseteils 18 an dem erste Gehäuseteil 11 (direkt oder vermittelt (nicht dargestellt) über ein Zwischenelement 45) der Zwischenbereich 32 keilförmig auf Grund unterschiedlicher Winkel γ1, γ2 des zweiten Abschnitts 20 und des ersten Abschnitts 13 zu einer Referenzebene zunehmend hin zu dem freien Ende des Abschnitts 13 des ersten Gehäuseteils 11 und des Abschnitts 20 des zweiten Gehäuseteils 18. Der Blechabschnitt 13 des ersten Gehäuseteils 11 und/oder der Blechabschnitt 20 des zweiten Gehäuseteils 18 können eine Einrichtung 39 zur Festlegung einer Biegezone 40 haben. Die Einrichtung 39 kann beispielsweise in einer Kerbe in dem Abschnitt des ersten Gehäuseteils 11 und/oder einer Kerbe des in dem Abschnitt des zweiten Gehäuseteils 18 bestehen. Andere Möglichkeiten sind eine Gefügeveränderung z.B. durch Erhitzen und/oder Umformen.

Zwischen dem zweiten Abschnitt 20 und dem ersten Abschnitt 13 ist ein Zwischenbereich 32 mit einer Keilspaltform gebildet, welcher durch Verspannung verengt wird, um diesen Zünddurchschlagsicher zu schließen. Bei einer Anlage auf Grund einer Form des ersten Gehäuseteils 11 und des zweiten Gehäuseteils 18, wie beispielsweise in Figur 9a, 9b gezeigt, bei der Innen ein geringerer Abstand zwischen den Abschnitten vorhanden ist als außen, wird die Kraft beim Verspannen verteilt, so dass Innen die größte Anlagekraft herrscht, um ein Aufweiten an dieser Stelle durch eine Explosion zu verhindern.

Figur 9c zeigt eine Abwandlung des Beispiels gemäß Figuren 9a, 9b. In dieser Abwandlung erweitert sich der Zwischenbereich 32 von außen nach innen (b>a).

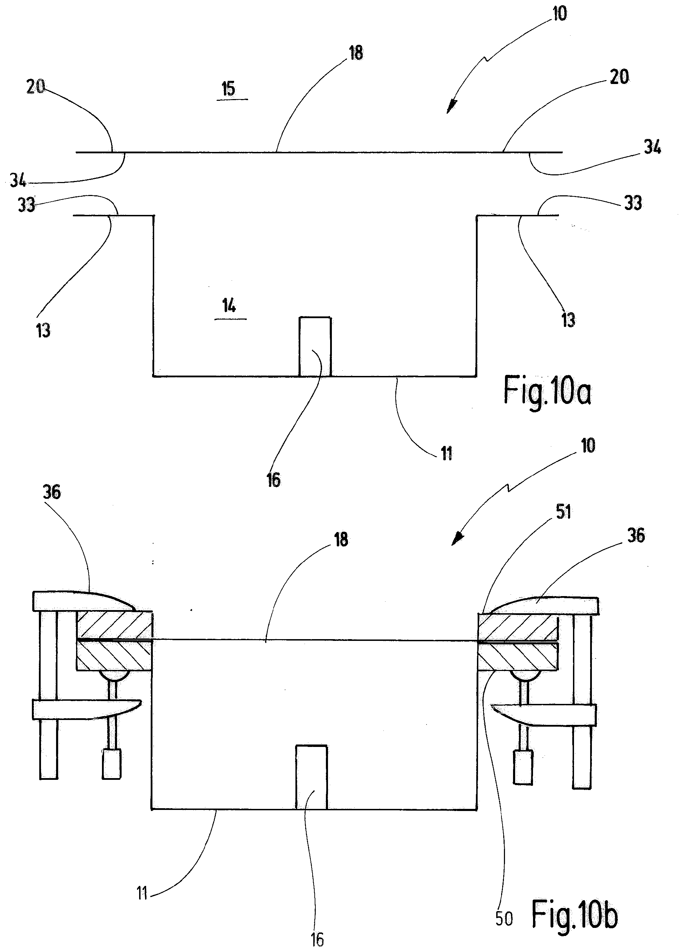

Figuren 10a und 10b zeigen ein Ausführungsbeispiel eines erfindungsgemäßen Gehäuses 10, in welchem der Flanschabschnitt 13 des ersten Gehäuseteils 11 und der Gegenabschnitt 20 (ein gedacht rahmenförmiger Abschnitt) des zweiten Gehäuseteils 18 komplementäre Sollformen aufweisen. Im dargestellten Ausführungsbeispiel weisen der erste Abschnitt 13 und der zweite Abschnitt 20 ebene, komplementäre Sollformen auf. Der erste Abschnitt 13 und der zweite Abschnitt 20 sind aber mit Toleranzen gefertigt, die so grob sind, dass erst von dem elastische Verformen des ersten Abschnitts 13 und/oder des zweiten Abschnitts 18 auf Grund des Verspannens der Zwischenbereich 32 zwischen dem ersten Gehäuseteil 11 und dem zweiten Gehäuseteil 18 zünddurchschlagsicher geschlossen wird. Eine Anlage des zweiten Gehäuseteils 18 an dem ersten Gehäuseteil 11 ohne Verspannen führt noch nicht sicher zu einer Geometrie des Zwischenbereichs 32, welche zünddurchschlagsicher ist. Der erste Abschnitt 13 des ersten Gehäuseteils 11 und der zweite Abschnitt 20 des zweiten Gehäuseteils 18 können beispielsweise eine Wanddicke von maximal 5mm, bevorzugt maximal 3mm, besonders bevorzugt maximal 2mm aufweisen. Bei derart geringer Wanddicke reicht bereits ein geringer Kraftbelag beim Verspannen aus, um eine Verformung zu erzielen, von welcher der Zwischenbereich 32 zünddurchschlagsicher geschlossen ist. Wie in den anderen Ausführungsbeispielen auch kann der erste Abschnitt 13 und/oder der zweite Abschnitt 20 aus Metallblech, insbesondere Stahlblech oder Aluminiumblech, oder aus Kunststoff bestehen.

Figur 10b zeigt die gegeneinander verspannten Gehäuseteile. Dazu ist eine Verspanneinrichtung 36 verwendet. Die Verspanneinrichtung 36 kann einen ersten, beispielsweise rahmenförmigen, Block 50 und einen zweiten, beispielsweise rahmenförmigen, Block 51 aufweisen, die mittels Klemmen gegeneinander gedrückt sind, um zwischen ihnen den Rahmenabschnitt 20 und den Flanschabschnitt 13 gegeneinander zu pressen. Aufgrund des Kraftbelags wird eine zünddurchschlagsichere Trennstelle 32 erreicht, welche auch im Explosionsfall im Innenraum 14 des Gehäuses 10 kein derart heißes Gas und/oder Partikel herauslässt, das zur Entzündung der Umgebung 15 geeignet wäre. Der Zwischenbereich 32 zwischen dem ersten Gehäuseteil 11 und dem zweiten Gehäuseteil 18 ist bis auf einen zünddurchschlagsicheren Spalt, beispielsweise einen 0-Spalt, geschlossen.

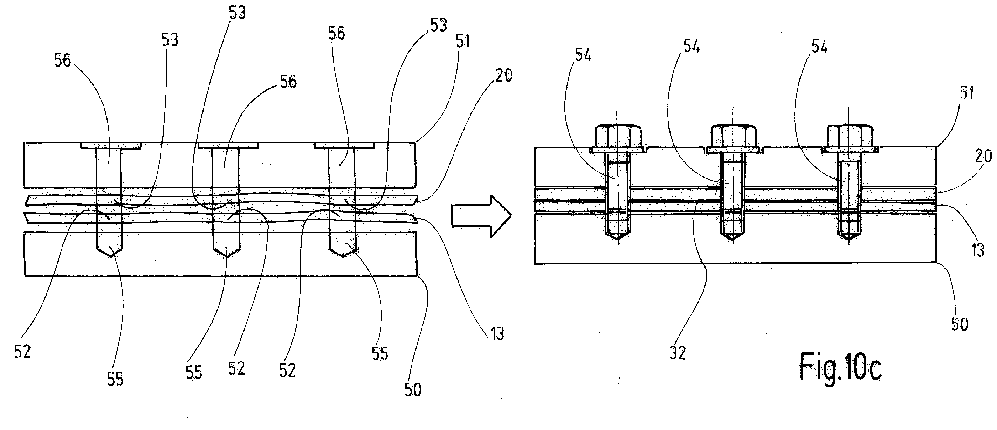

In Figur 10c, links ist in einer Seitenansicht stark schematisch veranschaulicht, dass der erste Abschnitt 13 und/oder der zweite Abschnitt 20 eine starke Wellenform aufgrund grober Fertigungstoleranzen aufweisen kann. Figur 10c zeigt eine zu Figur 10b alternative Verspanneinrichtung 36. In Abwandlung der Ausführungsform gemäß Figuren 10a, 10b weisen der erste Abschnitt 13 und der zweite Abschnitt 20 in dem Ausführungsbeispiel gemäß Figur 10c Ausnehmungen 52, 53, insbesondere Löchern, zum Durchführen von Bolzen 54, insbesondere Schrauben auf. Der oder die Blöcke 50, 51 weisen entsprechende Ausnehmungen 55, 56, insbesondere Löcher, zur Aufnahme der Bolzen 54 auf, welche durch die Ausnehmungen 52, 53 in dem ersten Abschnitt 13 und dem zweiten Abschnitt 20 geführt werden. Block 50 und/oder Block 51 kann insbesondere Gewindebohrungen aufweisen. Figur 10c, rechts zeigt in einer Schnittansicht längs eines Abschnitts des Umfangs des ersten Gehäuseteils 11 bzw. des zweiten Gehäuseteils 18 die Verspanneinrichtung 36 im verspannten Zustand. Die Blöcke 50, 51 drücken mittels der Bolzenverbindung 54 aufeinander zu, so dass der erste Abschnitt 13 und der zweite Abschnitt 20 miteinander verspannt sind und dadurch der Zwischenbereich 32 von der elastischen Verformung des ersten Abschnitts 13 und/oder des zweiten Abschnitts 20 zünddurchschlagsicher verschlossen ist. Die dargestellte abschnittsweise von Null verschiedene Spaltweite zwischen dem ersten Abschnitt 13 und dem zweiten Abschnitt 20 verdeutlicht, dass Zünddurchschlagsicherheit bei ausreichender großer Länge und kleiner Weite des spaltförmigen Zwischenbereichs 32 gegebenen ist, wobei diese beiden Größen in einem Zusammenhang stehen. Zwischen den Ausnehmungen 52, 53 in dem ersten Abschnitt 13 und dem zweiten Abschnitt 20 zur Aufnahme der Bolzen 54 und dem Innenraum 14 des Gehäuses 10 ist genügend Abstand, so dass der Zwischenbereich 32 gemessen von dem Innenraum 14 zu den Ausnehmungen 52, 53 eine ausreichende Länge für die Zünddurchschlagsicherheit aufweist.

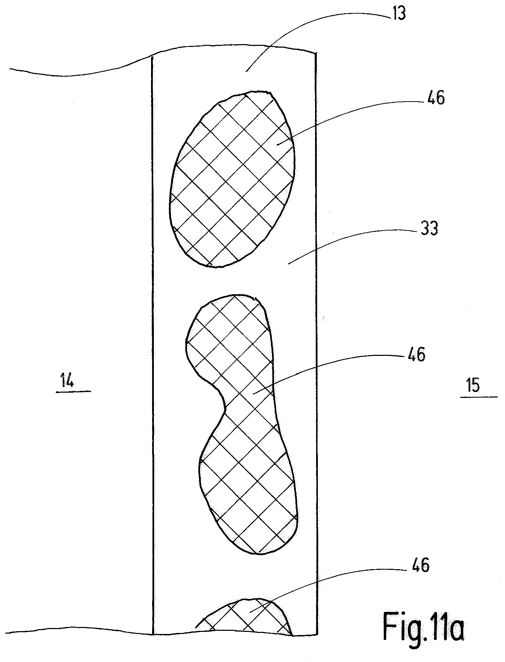

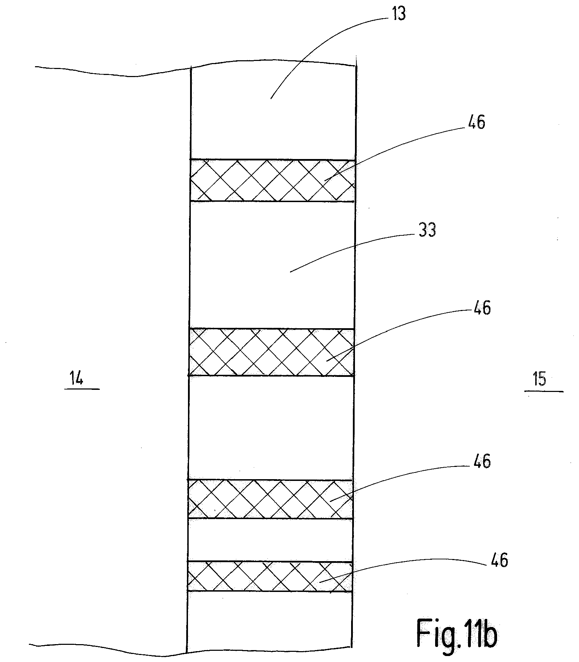

Figur 11a zeigt eine beispielhafte Ansicht auf die Fläche 33 des Abschnitts 13 des ersten Gehäuseteils 11 der Figur 10a und 10b. Figur 11b zeigt ein anderes Beispiel. Schraffiert veranschaulicht sind solche Bereiche 46, in denen die Fläche 34 des zweiten Abschnitts 13 des zweiten Gehäuseteils 18 an dem ersten Gehäuseteil 11 bereits im unverspannten Zustand zufällig anliegt. Diese Bereiche 46 sind von zufälliger Größe und Gestalt, z.B. inselförmig und/oder streifenförmig, und zufällig über die Fläche 33 des ersten Gehäuseteils 11 verteilt. Die Geometrie des Zwischenraums 32 durch einen Bereich 46 und/oder zwischen zwei Bereichen 46 ist im unverspannten Zustand nicht zünddurchschlagsicher. Wie im Zusammenhang mit den Figuren 10a und 10b erläutert wird der Zwischenbereich 32 erst von der elastischen Verformung geometrisch derart verengt, dass dieser zünddurchschlagsicher ist.

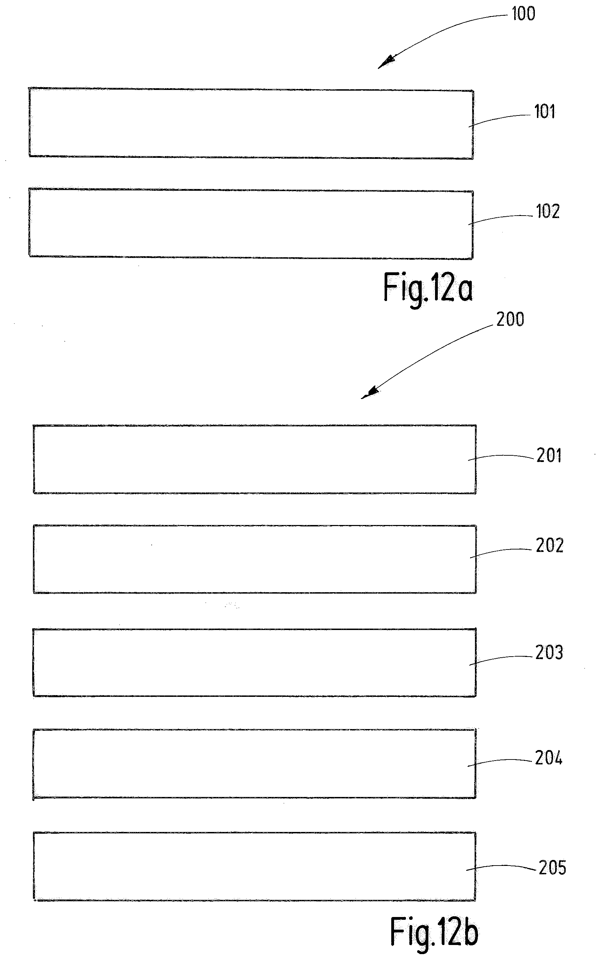

Die Figuren 12a, 12b veranschaulichen Beispiele der erfindungsgemäßen Verfahren 100, 200. In Figur 12 ist beispielhaft ein Verfahren 100 zum Herstellen eines Gehäuses 10 veranschaulicht, beispielsweise eines Gehäuses 10 wie vorstehend im Zusammenhang mit den Figuren 1 bis 11c beschrieben. Das Verfahren weist das Auswählen 101 eines ersten Abschnitts 13 und eines zweiten Abschnitts 20 zum Begrenzen eines Zwischenbereichs 32 des Gehäuses 10 auf, wobei wenigstens einer der Abschnitte 13, 20 ein Wandabschnitt ist. Der erste Abschnitt 13 und der zweite Abschnitt 20 werden danach ausgewählt, dass der erste Abschnitt 13 und der zweite Abschnitt 20 mittels einer Verspannvorrichtung 36 unter elastischer Verformung des Wandabschnitts 13, 20 gegeneinander drückbar sind (Block 102), so dass der Zwischenbereich 32 geometrisch von der elastischen Verformung des Wandabschnitts 13, 20 zünddurchschlagsicher geschlossen wird. Der erste Abschnitt 13 und der zweite Abschnitt 20 werden so aufeinander abgestimmt ausgewählt, hinsichtlich Form, Wandstärke, Material, Elastizitätsmodul und dgl., dass von der Verformung der Zwischenbereich 32 geometrisch zünddurchschlagsicher schließbar ist.

In Ausführungsformen, in denen der erste Abschnitt 13 und der zweite Abschnitt 20 jeweils Blechabschnitte sind, wird durch die Anlage ein Zwischenbereich 32 mit einer elastisch anpassbaren Blechspaltgeometrie gebildet, welcher von der Verformung des wenigstens einen Wandabschnitts 13, 20 geometrisch verengt wird, um diesen zünddurchschlagsicher zu schließen.

Figur 12b veranschaulicht ein Verfahren 200 zum Herstellen einer explosionsgeschützten Verbindung zwischen einem ersten Abschnitt 13 eines ersten Gehäuseteils 11 mit einer ersten Fläche 33 und einem zweiten Abschnitt 20 eines zweiten Gehäuseteils 18 mit einer zweiten Fläche 34 eines Gehäuses 10 wie beispielsweise im Zusammenhang mit Figuren 1 bis 11c beschrieben. Wenigstens einer der Abschnitte 13, 20 ist ein Wandabschnitt. Das Verfahren 200 weist das Zusammensetzen 201 des ersten Gehäuseteils 11 und des zweiten Gehäuseteils 18 auf, um das Gehäuse 10 zu schließen. Bei Zusammengesetztem ersten Gehäuseteil 11 und zweitem Gehäuseteil 18 begrenzen die erste Fläche 33 und die zweite Fläche 34 einen Zwischenbereich 32, welcher ein Spaltmaß außerhalb eines zünddurchschlagsicheren Bereichs aufweist. Es erfolgt ein Beaufschlagen 202 der Abschnitte 13, 20 mit einer Kraft, wobei die Abschnitte 13, 20 unter elastischer Verformung des wenigstens einen Wandabschnitts 13, 20 gegeneinander gedrückt werden, so dass der Zwischenbereich 32 von der elastischen Verformung des Wandabschnitts 13, 20 zünddurchschlagsicher geometrisch geschlossen wird. In Ausführungsformen werden der erste Abschnitt 11 und der zweite Abschnitt 18 aufeinander zu verformt, wobei der erste Abschnitt 11 und der zweite Abschnitt 18 je nach elastischer Nachgiebigkeit unterschiedliche Abschnitte der zum zünddurchschlagsicheren Verschließen erforderlichen Strecke S zurücklegen. Die Verformung wird geometrisch dazu benutzt den Zwischenraum 32 zu schließen.

Bevorzugt ist die Verbindung wiederherstellbar. Dazu wird die Verspannung gelöst 203 und das zweite Gehäuseteil 18 von dem ersten Gehäuseteil 11 entfernt 204. Das zweite Gehäuseteil 18 und des erste Gehäuseteil 11 können zum Wiederherstellen 205 der Verbindung wieder in Anlage gebracht werden und das Verfahren gemäß Figur 12b kann wiederholt angewendet werden.

Es wird ein explosionsgeschütztes Gehäuse (10) angegeben, welches einen Innenraum 14 zur Aufnahme von Komponenten 16 bildet, welche Zündquellen bilden können. Das Gehäuse weist ein erstes Gehäuseteil 11 mit einem ersten Abschnitt 13, welcher eine erste Fläche 33 aufweist, und ein zweites Gehäuseteil 18 mit einem zweiten Abschnitt 20, welcher eine zweite Fläche 34 aufweist, auf, wobei der erste Abschnitt 13 und/oder der zweite Abschnitt 20 ein Abschnitt einer Wand 12, 19 ist, wobei die erste Fläche 33 und die zweite Fläche 34 einen Zwischenbereich 32 begrenzen. Der erste Abschnitt 13 und der zweite Abschnitt 20 sind unter elastischer Verformung des Wandabschnitts 13, 20 gegeneinander gedrückt, so dass der Zwischenbereich 32 geometrisch von der elastischen Verformung des Wandabschnitts 13, 20zünddurchschlagsicher geschlossen ist. Es wird zudem ein Verfahren 200 zum Herstellen einer explosionsgeschützten Verbindung zwischen einem ersten Abschnitt 13 eines ersten Gehäuseteils 11 mit einer ersten Fläche 33 und einem zweiten Abschnitt 20 eines zweiten Gehäuseteils 18 mit einer zweiten Fläche 34 eines Gehäuses 10 angegeben, wobei wenigstens einer der Abschnitte ein Abschnitt 13, 20 einer Wand ist. Es wird ein weiteres Verfahren 200 zum Herstellen einer explosionsgeschützten Verbindung zwischen einem ersten Abschnitt 13 eines ersten Gehäuseteils 11 mit einer ersten Fläche 33 und einem zweiten Abschnitt 20 eines zweiten Gehäuseteils 18 mit einer zweiten Fläche 34 eines Gehäuses 10 angegeben, wobei wenigstens einer der Abschnitte ein Abschnitt 13, 20 einer Wand 12, 19 ist.

### Bezugszeichenliste:

| | |
|---|---|
| 10 | Gehäuse |
| 11 | Erstes Gehäuseteil |
| 12 | Wand |
| 13 | Erster Abschnitt/Wandabschnitt/Flanschabschnitt |
| 14 | Innenraum |
| 15 | Umgebung |
| 16 | Komponenten |
| 17 | Öffnung |
| 18 | Zweites Gehäuseteil |
| 19 | Wand |
| 20 | Zweite Abschnitt/Wandabschnitt/Randabschnitt |
| 21a | Druckentlastungsöffnung |
| 21b | Druckentlastungskörper |
| 22 | Äußere Druckentlastungsvorrichtung |
| 23 | Innere Druckentlastungsvorrichtung |
| 24 | Poröses Material |
| 25 | Sicke |
| 26 | Boden |
| 27a | Druckentlastungsöffnung |
| 27b | Druckentlastungskörper |
| 28 | äußere Druckentlastungsvorrichtung |
| 29 | Weitere Sicke |
| 30 | Aufnahme |
| 31 | Abstützbereich |
| 32 | Zwischenbereich |
| 33 | Erste Fläche |
| 34 | Zweite Fläche |
| 35 | Verspannbereich |
| 36 | Verspannvorrichtung |
| 38 | Rücken |
| 39 | Einrichtung |
| 40 | Biegezone |
| 45 | Zwischenrahmen |
| 46 | Bereich |
| 50 | Block |
| 51 | Block |
| 52 | Ausnehmung |
| 53 | Ausnehmung |
| 54 | Bolzen |
| 55 | Ausnehmung |
| 56 | Ausnehmung |
| 100 | Verfahren |
| 101 | Auswählen |
| 200 | Verfahren |
| 201 | Zusammensetzen |
| 202 | Beaufschlagen |
| 203 | Lösen der Verspannung |
| 204 | Entfernen |
| 205 | Wiederherstellen der Verbindung |
| r1 | Radius |
| r2 | Radius |
| α1 | Winkel |
| α2 | Winkel |
| β | Winkel |
| S | Strecke |

## Patentansprüche

1. Explosionsgeschütztes Gehäuse (10), welches einen Innenraum (14) zur Aufnahme von Komponenten (16) bildet, welche Zündquellen bilden können, mit einem ersten Gehäuseteil (11) mit einem ersten Abschnitt (13), welcher eine erste Fläche (33) aufweist, und einem zweiten Gehäuseteil (18) mit einem zweiten Abschnitt (20), welcher eine zweite Fläche (34) aufweist, wobei der erste Abschnitt (13) und/oder der zweite Abschnitt (20) ein Wandabschnitt ist, wobei die erste Fläche (33) und die zweite Fläche (34) einen Zwischenbereich (32) begrenzen, wobei der erste Abschnitt (13) und der zweite Abschnitt (20) unter elastischer Verformung des Wandabschnitts (13, 20) mittels einer Verspannvorrichtung (36) gegeneinander gedrückt sind, so dass der Zwischenbereich (32) geometrisch von der elastischen Verformung des Wandabschnitts (13, 20) zünddurchschlagsicher geschlossen ist.

2. Gehäuse (10) nach Anspruch 1, wobei der erste Abschnitt (13) ein Blechabschnitt und/oder der zweite Abschnitt (20) ein Blechabschnitt ist.

3. Gehäuse (10) nach Anspruch 2, wobei die Blechdicke des ersten Abschnitts (13) und/oder des zweiten Abschnitts (20) maximal 5 Millimeter oder bevorzugt maximal 3 Millimeter beträgt.

4. Gehäuse (10) nach einem der vorstehenden Ansprüche, wobei der erste Abschnitt (13) zu einem ersten Gehäuseteil (11) gehört und wobei der zweite Abschnitt (20) zu einem zweiten Gehäuseteil (18) gehört, wobei der erste Abschnitt (13) und der zweite Abschnitt (20) bei Anlage des ersten Gehäuseteils (11) an dem zweiten Gehäuseteil (18), im unverspannten Zustand auf Grund der geometrischen Sollform des ersten Abschnitts (13) und des zweiten Abschnitts (20) einen Winkel einschließen.

5. Gehäuse (10) nach einem der vorstehenden Ansprüche, wobei die Weite des Zwischenbereichs (32) bei Anlage des ersten Gehäuseteils (11) und des zweiten Gehäuseteils (18) aneinander im unverspannten Zustand auf Grund der Sollform des ersten Abschnitts (11) und des zweiten Abschnitts (18) von einem Abstützbereich (31) in Richtung zu der Umgebung (15) des Gehäuses (10) und/oder in Richtung zum Innenraum (14) zunimmt.

6. Gehäuse (10) nach einem der vorstehenden Ansprüche, wobei sich der zweite Abschnitt (18) an dem ersten Abschnitt (11) beim zünddurchschlagsicheren Schließen des Zwischenbereichs (32) durch elastisches Verformen direkt oder indirekt in einem festgelegten Abstützbereich (31) abstützt, wobei der Abstützbereich (31) einen inneren Rand und/oder einen äußeren Rand des Zwischenbereichs (32) bildet und/oder wobei der Abstützbereich (32) zwischen einem inneren Rand und einem äußeren Rand des Zwischenbereichs (32) angeordnet ist.

7. Gehäuse (10) nach einem der vorstehenden Ansprüche, wobei der erste Abschnitt (13) und/oder der zweite Abschnitt (20) eine langgestreckte Aufnahme (30) bildet und wobei der zweite Abschnitt (20) und/oder der erste Abschnitt (13) wenigstens eine langgestreckte Vorwölbung (38) aufweist, welche in der Aufnahme (30) aufgenommen ist.

8. Gehäuse (10) nach einem der vorstehenden Ansprüche, wobei zwischen dem ersten Abschnitt (11) und dem zweiten Abschnitt (18) wenigstens ein elastisch verformtes Zwischenelement (32) angeordnet ist, vermittelt über welches der erste Abschnitt (11) und der zweite Abschnitt (18) gegeneinander gedrückt sind.

9. Gehäuse (10) nach Anspruch 8, wobei das Zwischenelement (32) rahmenförmig ist.

10. Gehäuse (10) nach einem der vorstehenden Ansprüche, wobei die den Zwischenbereich (32) begrenzende erste Fläche (33) des ersten Abschnitts (13) und/oder die den Zwischenbereich (32) begrenzende zweite Fläche (34) des zweiten Abschnitts (18), schräg relativ zu einer Wand (19) des Gehäuses (10) orientiert ist.

11. Gehäuse (10) nach einem der vorstehenden Ansprüche, wobei der erste Abschnitt (13) und/oder der zweite Abschnitt (20) eine Einrichtung (39) zur Festlegung einer Biegezone (40) aufweist.

12. Gehäuse (10) nach einem der vorstehenden Ansprüche, wobei das Gehäuse (10) wiederverschließbar ist.

13. Gehäuse (10) nach einem der vorstehenden Ansprüche, wobei dem Gehäuse (10) einen innere Druckentlastungsvorrichtung (23) und/oder eine äußere Druckentlastungsvorrichtung (22, 28) zugeordnet ist.

14. Verfahren (100) zum Herstellen eines explosionsgeschützten Gehäuses (10), beispielsweise nach einem der vorstehenden Ansprüche, wobei das Verfahren (100) aufweist:
Auswählen (101) eines ersten Abschnitts (13) und eines zweiten Abschnitts (20) zum Begrenzen eines Zwischenbereichs (32) des Gehäuses (10), wobei wenigstens einer der Abschnitte (13, 20) ein Wandabschnitt ist, derart, dass der erste Abschnitt (13) und der zweite Abschnitt (20) unter elastischer Verformung des Wandabschnitts (13, 20) mittels einer Verspannvorrichtung (36) gegeneinander drückbar sind, so dass der Zwischenbereich (32) geometrisch von der elastischen Verformung des Wandabschnitts (13, 20) zünddurchschlagsicher geschlossen wird.

15. Verfahren (200) zum Herstellen einer explosionsgeschützten Verbindung zwischen einem ersten Abschnitt (13) eines ersten Gehäuseteils (11) mit einer ersten Fläche (33) und einem zweiten Abschnitt (20) eines zweiten Gehäuseteils (18) mit einer zweiten Fläche (34) eines Gehäuses (10), beispielsweise nach einem der Ansprüche 1 bis 13, wobei wenigstens einer der Abschnitte ein Wandabschnitt (13, 20) ist, mit den Schritten:
- Zusammensetzen (201) des ersten Gehäuseteils (11) und des zweiten Gehäuseteils (18), um das Gehäuse (10) zu schließen, wobei die erste Fläche (33) und die zweite Fläche (34) einen Zwischenbereich (32) begrenzen, welcher ein Spaltmaß außerhalb eines zünddurchschlagsicheren Bereichs aufweist,
- Beaufschlagen (202) der Abschnitte (13, 20) mit einer Verspannkraft, so dass die Abschnitte (13, 20) unter elastischer Verformung des Wandabschnitts (13, 20) gegeneinander gedrückt werden, so dass der Zwischenbereich (32) von der elastischen Verformung des Wandabschnitts (13, 20) zünddurchschlagsicher geometrisch geschlossen wird.

16. Verfahren (200) nach dem vorstehenden Anspruch, wobei eine Strecke (S) zum Verschließen des Zwischenbereichs (32), so dass dieser zünddurchschlagsicher ist, überwiegend durch Verformung von dem Wandabschnitt (13, 20) zurückgelegt wird.

## Claims

1. An explosion-proof housing (10) which forms an interior (14) for accommodating components (16) that can form ignition sources, with a first housing part (11) that has a first section (13) that comprises a first surface (33) and a second housing part (18) that has a second section (20) that comprises a second surface (34), wherein the first section (13) and/or the second section (20) is a wall section, wherein the first surface (33) and the second surface (34) delimit an intermediate region (32), wherein the first section (13) and the second section (20) are pressed against one another by means of a clamping device under elastic deformation of the wall section (13, 20), so that the intermediate region (32) is geometrically closed in a flameproof manner by the elastic deformation of the wall section (13, 20).

2. The housing (10) according to claim 1, wherein the first section (13) is a sheet section and/or the second section (20) is a sheet section.

3. The housing (10) according to claim 2, wherein the sheet thickness of the first section (13) and/or the second section (20) is a maximum of 5 millimeters or preferably a maximum of 3 millimeters.

4. The housing (10) according to any of the preceding claims, wherein the first section (13) is part of a first housing part (11) and the second section (20) is part of a second housing part (18), wherein the first section (13) and the second section (20) enclose an angle when the first housing part (11) and the second housing part (18) abut against one another in the non-clamped condition due to the geometric desired shape of the first section (13) and the second section (20).

5. The housing (10) according to any of the preceding claims, wherein the width of the intermediate region (32) increases from a support region (31) in the direction toward the environment (15) of the housing (10) and/or in direction toward the interior (14) when the first housing part (11) and the second housing part (18) abut against one another in the non-clamped condition due to the desired shape of the first housing part (11) and the second housing part (18).

6. The housing (10) according to any of the preceding claims, wherein the second section (18) is supported on the first section (11) during flameproof closing of the intermediate region (32) by elastic deformation directly or indirectly in a defined support region (31), wherein the support region (31) forms an inner edge of the intermediate region (32) and/or wherein the support region (32) is arranged between an inner edge and an outer edge of the intermediate region (32).

7. The housing (10) according to any of the preceding claims, wherein the first section (13) and/or the second section (20) forms an elongated receptacle (30) and wherein the second section (20) and/or the first section (13) comprises at least one elongated dome (38) that is located inside the receptacle (30).

8. The housing (10) according to any of the preceding claims, wherein at least one elastically deformed intermediate element (32) is arranged between the first section (11) and the second section (18), via which the first section (11) and the second section (18) are pressed against one another.

9. The housing (10) according to claim 8, wherein the intermediate element (32) is frame-shaped.

10. The housing (10) according to any of the preceding claims, wherein the first surface (33) of the first section (13) delimiting the intermediate region (32) and/or the second surface (34) of the second section (18) delimiting the intermediate region (32) is orientated obliquely relative to a wall (19) of the housing (10).

11. The housing (10) according to any of the preceding claims, wherein the first section (13) and/or the second section (20) comprises a device (39) for defining a bending zone (40).

12. The housing (10) according to any of the preceding claims, wherein the housing (10) is reclosable.

13. The housing (10) according to any of the preceding claims, wherein an internal pressure relief device (23) and/or an external pressure relief device (22, 28) is assigned to the housing (10).

14. A method (100) for manufacturing a flameproof housing (10), for example according to any of the preceding claims, wherein the method (100) comprises:
selecting (101) a first section (13) and a second section (20) for delimiting an intermediate region (32) of the housing (10), wherein at least one of the sections (13, 20) is a wall section, such that the first section (13) and the second section (20) can be pressed against one another under elastic deformation of the wall section (13, 20) by means of a clamping device, so that the intermediate region (32) is geometrically closed in a flameproof manner by the elastic deformation of the wall section (13, 20).

15. A method (200) for establishing an explosion-proof connection between a first section (13) of a first housing part (11) having a first surface (33) and a second section (20) of a second housing part (18) having a second surface (34) of a housing (10), for example according to any of the claims 1 to 13, wherein at least one of the sections is a wall section (13, 20), comprising the steps:
- assembling (201) the first housing part (11) and the second housing part (18) in order to close the housing (10), wherein the first surface (33) and the second surface (34) delimit an intermediate region (32) comprising a gap dimension outside a flameproof range,
- applying (202) a clamping force on the sections (13, 20) such that the sections (13, 20) are pressed against one another under elastic deformation of the wall section (13, 20), so that the intermediate region (32) is geometrically closed in a flameproof manner by the elastic deformation of the wall section (13, 20).

16. The method (200) according to the preceding claim, wherein a distance (S) for closing the intermediate region (32), so that it is flameproof, is predominantly covered by the deformation of the wall section (13, 20).

## Revendications

1. Boîtier antidéflagrant (10) qui forme un espace intérieur (14) destiné à accueillir des composants (16) pouvant constituer des sources d'inflammation, comprenant une première partie de boîtier (11) avec une première portion (13) présentant une première surface (33), et une deuxième partie de boîtier (18) avec une deuxième portion (20) présentant une deuxième surface (34), la première portion (13) et/ou la deuxième portion (20) étant une portion de paroi, la première surface (33) et la deuxième surface (34) délimitant une zone intermédiaire (32), la première portion (13) et la deuxième portion (20) étant pressées l'une contre l'autre avec déformation élastique de la portion de paroi (13, 20), au moyen d'un dispositif de serrage (36), de manière à ce que la zone intermédiaire (32) soit fermée géométriquement de façon antidéflagrante par la déformation élastique de la portion de paroi (13, 20).

2. Boîtier (10) selon la revendication 1, dans lequel la première portion (13) est une portion en tôle et/ou la deuxième portion (20) est une portion en tôle.

3. Boîtier (10) selon la revendication 2, dans lequel l'épaisseur de tôle de la première portion (13) et/ou de la deuxième portion (20) est au maximum de 5 millimètres ou de préférence au maximum de 3 millimètres.

4. Boîtier (10) selon une des revendications précédentes, dans lequel la première portion (13) fait partie d'une première partie de boîtier (11), et dans lequel la deuxième portion (20) fait partie d'une deuxième partie de boîtier (18), sachant que lorsque la première partie de boîtier (11) est appliquée contre la deuxième partie de boîtier (18) à l'état non serré, la première portion (13) et la deuxième portion (20) forment un angle en raison de la forme de consigne géométrique de la première portion (13) et de la deuxième portion (20).

5. Boîtier (10) selon une des revendications précédentes, dans lequel, lorsque la première partie de boîtier (11) et la deuxième partie de boîtier (18) sont appliquées l'une contre l'autre à l'état non serré, la largeur de la zone intermédiaire (32) augmente à partir d'une zone d'appui (31) en direction de l'environnement (15) du boîtier (10) et/ou en direction de l'espace intérieur (14), en raison de la forme de consigne de la première partie (11) et de la deuxième partie (18).

6. Boîtier (10) selon une des revendications précédentes, dans lequel, lors de la fermeture antidéflagrante de la zone intermédiaire (32), la deuxième partie (18) prend appui par déformation élastique sur la première partie (11), directement ou indirectement dans une zone d'appui (31) définie, la zone d'appui (31) formant un bord intérieur et/ou un bord extérieur de la zone intermédiaire (32), et/ou la zone d'appui (32) étant disposée entre un bord intérieur et/ou un bord extérieur de la zone intermédiaire (32).

7. Boîtier (10) selon une des revendications précédentes, dans lequel la première portion (13) et/ou la deuxième portion (20) forment un logement (30) allongé, et dans lequel la deuxième portion (20) et/ou la première portion (13) présentent au moins une protubérance (38) allongée qui est accueillie dans le logement (30).

8. Boîtier (10) selon une des revendications précédentes, dans lequel au moins un élément intermédiaire (32) déformé élastiquement est disposé entre la première partie (11) et la deuxième partie (18), élément au moyen duquel la première partie (11) et la deuxième partie (18) sont pressées l'une contre l'autre.

9. Boîtier (10) selon la revendication 8, dans lequel l'élément intermédiaire (32) a la forme d'un cadre.

10. Boîtier (10) selon une des revendications précédentes, dans lequel la première surface (33) de la première portion (13), qui délimite la zone intermédiaire (32), et/ou la deuxième surface (34) de la deuxième portion (18), qui délimite la zone intermédiaire (32), est/sont orientée(s) en biais par rapport à une paroi (19) du boîtier (10).

11. Boîtier (10) selon une des revendications précédentes, dans lequel la première portion (13) et/ou la deuxième portion (20) présente(nt) un dispositif (39) destiné à définir une zone de flexion (40).

12. Boîtier (10) selon une des revendications précédentes, dans lequel le boîtier (10) peut être refermé.

13. Boîtier (10) selon une des revendications précédentes, dans lequel un dispositif de décompression interne (23) et/ou un dispositif de décompression externe (22, 28) est associé au boîtier (10).

14. Procédé (100) de fabrication d'un boîtier antidéflagrant (10), par exemple selon une des revendications précédentes, le procédé (100) comprenant :
la sélection (101) d'une première portion (13) et d'une deuxième portion (20) aux fins de délimiter une zone intermédiaire (32) du boîtier (10), au moins une des portions (13, 20) étant une portion de paroi, de façon que la première portion (13) et la deuxième portion (20) puissent être pressées l'une contre l'autre au moyen d'un dispositif de serrage (36), avec déformation élastique de la portion de paroi (13, 20), de manière à ce que la zone intermédiaire (32) soit fermée géométriquement de façon antidéflagrante par la déformation élastique de la portion de paroi (13, 20).

15. Procédé (200) de réalisation d'un assemblage antidéflagrant entre une première portion (13) d'une première partie de boîtier (11), comportant une première surface (33), et une deuxième portion (20) d'une deuxième partie de boîtier (18), comportant une deuxième surface (34), d'un boîtier (10), par exemple selon une des revendications 1 à 13, où au moins une des portions est une portion de paroi (13, 20), comprenant les étapes suivantes :
- assemblage (201) de la première partie de boîtier (11) et de la deuxième partie de boîtier (18) pour fermer le boîtier (10), la première surface (33) et la deuxième surface (34) délimitant une zone intermédiaire (32) qui présente une dimension d'intervalle à l'extérieur d'une zone antidéflagrante,
- application d'une force de serrage aux portions (13, 20), de façon que les portions (13, 20) soient pressées l'une contre l'autre avec déformation élastique de la portion de paroi (13, 20), de manière à ce que la zone intermédiaire (32) soit fermée géométriquement de façon antidéflagrante par la déformation élastique de la portion de paroi (13, 20).

16. Procédé (200) selon la revendication précédente, selon lequel un trajet (S) pour la fermeture de la zone intermédiaire (32), pour faire en sorte que celle-ci soit antidéflagrante, est parcouru principalement par déformation de la portion de paroi (13, 20).
